# EUROPEAN PATENT APPLICATION

(11) **EP 1 172 693 A1**
(43) Date of publication of application: **16.01.2002**
(21) Application number: 01901542.9
(22) Date of filing: 24.01.2001
(51) Int. Cl.: G03F 7/027, C08F 290/06, C08F 2/50, G03F 7/004, G02B 5/20

(54) **PHOTOCURABLE RESIN COMPOSITIONS**

(30) Priority: 25.01.2000 JP 2000016255; 18.04.2000 JP 2000116288; 24.11.2000 JP 2000358537
(71) Applicant: DAICEL CHEMICAL INDUSTRIES, Ltd., Sakai-shi, Osaka 590-0905 (JP)
(72) Inventor: MIYAKE, Hiroto, Otake-shi, Hiroshima 739-0651 (JP); MARUO, Katsuya, Ohtake-shi, Hiroshima 739-0651 (JP); OKITSU, Kiyoshi, Shizuoka-shi, shizuoka 422-8055 (JP)
(74) Representative: Portal, Gérard
(86) International application number: JP0100459
(87) International publication number: WO0155790

(57) **Abstract**

In the present invention I, it was able to develop by water, and water resistance is improved in a cured coating layer owing to a photocurable resin composition containing a resin having hydroxyl groups and a polymerizable unsaturated groups, a photopolymerizable initiator, and a photo-polymerizable monomer, and it becomes unnecessary to conduct pH control of a developer which is problematic in alkali development.

The present invention II provides a method for the preparation of PDP ribs in which residual carbon can be suppressed as low as possible in the formation of the PDP ribs using a photocurable resin composition in which a solvent for dilution is further added to the photocurable resin composition of the present invention I, by which a storage stability is improved.

The resin composition of the present invention III provides a liquid-state photoresist resin composition for a printed circuit board, in which solubility and stability are elevated in the preparation of a resist composition and residual solvents are decreased in a resist layer during the preparation of the resist layer, and there are improved physical properties such as uniformity of line width and adhesion of the resist layer in development by using a resin composition in which organic solvents and/or a polymerizable vinyl monomer are formulated with a modified copolymer obtained by an addition reaction of a carboxylic group containing resin with an ethylenic unsaturated compound containing a cycloaliphatic epoxy group, and the carboxylic group containing resin is obtained by a polymerization of an ethylenic unsaturated compound containing carboxylic group as an essential component.

The present invention IV provides a photocurable resin composition which is well-balanced between an ink sensitivity and tackiness which are shown by step stage evaluations, which contains a carboxylic group containing - teminated monomer composition in which a hydroxyl group containing - teminated acrylate is modified by an acid anhydride and, in the hydroxyl group containing - teminated acrylate, 0.3-1 mol of ε-caprolactone is added to 1 mol of a hydroxyalkyl(meth)acrylate.

## Description

### TECHNICAL FIELD

The present invention No. I relates to a photocurable resin composition containing a resin in which a polymerizable unsaturated group is introduced into a resin having hydroxyl groups, and a photopolymerization initiator, a photopolymerizable monomer as essential components, that is, a photocurable resin composition which can readily provide a picture image by photoirradiation and developing by water after forming a thin layer, a photocurable resin composition or a thermosetting resin composition in which the composition is mixed with a composition for a specified use such as a material for forming a picture image.

The present invention II relates to a method for the preparation of a separating rib (hereinafter, occasionally referred to as a rib) for a plasma display panel (hereinafter, occasionally referred to as PDP) using the photocurable resin composition of the present invention I.

The present invention III relates to a resin composition for a liquid-state etching resist or a solder resist which is employed in a preparation step of a printed circuit board.

The present invention IV relates to a monomer composition in which a specified (meth)acrylate compound having a terminal hydroxyl group is modified by an acid anhydride, and relates to a photo-curable resin composition containing a specified (meth)acrylic acid derivative monomer composition.

### BACKGROUND ART

Heretofore, in an etching resist binder for a printed circuit board, there has been widely employed an acrylic resin having carboxylic groups as an alkali-developable resist binder.

However, in the case that the acrylic resin having carboxylic groups and a polyfunctional monomer are employed as a component for the alkali-developable resist binder and in the case of an etching resist ink using a photocurable system is prepared, various problems are pointed.

As the various problems, there are enumerated (1) water resistance is poor in a photocurable coating layer because of the absence of a photocuring reaction portion in the resin itself which is a component in the binder composition, (2) it is difficult to constantly maintain conditions such as a developing time of period because of a readily changing property in pH of a developer in an alkali-developable type, (3) it is difficult to develop by water or a diluted alkali instead of an alkali-development, and residual substances are remained during developing, (4) residual carbon substances are remained in a step of decomposition and removal of resins by a high temperature burning in the case of the formation of a PDP rib, and (5) a composition is poor in storage stability because of a high carboxylic group content, etc.

Herein, the PDP is a plain display which displays a picture image and information at a front surface through luminescence of a phosphor by gas discharging. The phosphor is coated on internal bottom surface of many cells which are separating and formed by front and back of two glass substrates and a glass-made separating rib (a barrier rib). The PDP is classified into a DC type and AC type depending upon a panel structure and a driving method.

In the DC type PDP, space of each cell is separated by lattice-shaped ribs and, on the other hand, in the AC type PDP, space of each cell is separated by U-shaped tubular ribs which are attached in parallel on surface of glass-made substrates, and even in any of the both type, separation of cell space is formed by ribs.

The ribs are formed in order to limit luminescent discharging within a fixed range, so that an excellent discharging is attained without error discharging and cross-talk between discharged cells, a uniform discharging space is maintained depending upon the height, width, and a pattern gap, and it has a function elevating mechanical strength in a whole of a panel.

For that reason, in order to obtain a high luminescent intensity in the PDP, it is required that a space for gas discharge is designed as widely as possible, and the ribs are designed as thinly as possible. That is, it is required to form narrow and tall ribs having a large height/width ratio (aspect ratio) and sufficient strength.

Heretofore, in the ribs for the PDP, glass-made ribs were usually formed by burning organic components in a calcine step after having conducted a patterning of a photocurable resin paste, etc. containing glass flit using a screen printing method. In the case that the patterning is conducted by the screen printing method, it is required to conduct a plurality of printing (repeated coatings) because of thick coating layer. However, it is difficult to adjust slackening of a screen during repeated coatings and pressure control in squeegee, and a slip is caused, whereby, there increases inferiority ratio of the ribs.

Further, for a shift of a PDP to large-sizing and a shift of a pattern to high precision and fining, skillfulness is required in the conventional screen printing method, and there have been problems of blur and blot during printing, and a problem of accuracy in positioning which is caused by extension and shrinkage of screen, whereby, there has been a problem of an increase in inferiority ratio of ribs.

Therefore, as a method for the formation of a rib which is capable of being replaced with the screen printing method, a photolithographic method is proposed (for example, JP-A-02165538 Official Gazette). Further, there is proposed (for example, JP-A-06144871 Official Gazette) the addition of a black-colored pigment in order to prevent a halation during curing by an ultraviolet ray.

In the photolithographic method, an ultraviolet ray-curable glass powder paste material is coated on a glass-made substrate, and a rib pattern is formed by photoexposing and developing.

However, since a conventionally known material is of an organic solvent-developable type material and a large amount of a developer is employed for removal (that is, development) of an uncured portion after photocuring, there have been a problem of deterioration in working circumstances and a problem of profitability. For that reason, there has been desired a development of a non organic solvent-developable type material, as a result, there has become proposed an ultraviolet ray-curable type glass powder paste material which can be developed in a state of an alkaline aqueous solution.

As a method which can be developed by an alkali for formation of a rib, JP-A-10072240 Official Gazette discloses a method. In the method, there is employed a resin in which glycidyl(meth)acrylate is added to an acrylic resin having acid groups.

However, glycidyl(meth)acrylate alone can be practically employed from a viewpoint of harmfulness of a solvent, and it includes a problem of a low sensitivity and resolution.

By the way, it is generally known to employ a polymer compound having carboxylic groups as an ultraviolet ray-curable resin in order to modify an ultraviolet ray-curable type resin composition to an alkali-developable type which is a useful means from a viewpoint of protection of a working circumstance.

However, in the case that the polymeric compound having carboxylic groups is formulated with a glass paste composition to be employed for forming ribs in the PDP, viscosity stability is exceedingly poor in a paste obtained and it is not appropriate for a practical use.

That is, in the case that the viscosity stability is poor in the glass paste composition, it becomes difficult to stably form a rib pattern having a constant large aspect ratio, and it becomes largely problematic in a function of the PDP.

Further, there is a problem that workability in coating becomes poor by gelation and a decline of flowability in a composition.

Still further, a precision processing is required in the preparation of the printed circuit board, and a photoresist has been conventionally utilized for satisfying a requirement thereof.

As a photoresist to be utilized, there are a screen ink, a dry film resist, an electro-deposition resist, and a liquid-state resist, etc.

In recent years, the liquid-state resist (a liquid-state resist for a photoresist is referred to as a liquid-state photoresist) has been watched.

In the liquid-state resist, since coating layer thickness of a resist can be thinned such as in layer thickness of the electro-deposition resist compared to the dry film resist, there can be expected dissolution degree such as in the electro-deposition resist or more degree from a viewpoint of formability of a micropattern.

Further, since bath control is not required such as in the electro-deposition and it can also be more reduced in costs than in the electro-deposition from a viewpoint of investment for an apparatus, it is hopeful as a method for the formation of a micropattern.

As a solvent to be employed for a liquid-state photoresist (hereinafter, it is occasionally abbreviated as a resist), there have been conventionally known a variety of solvents, and there are selected and employed appropriate solvents in consideration of solubility, coatability, sensitivity, and developability of a resist resin composition. As a solvent which is excellent in a various properties such as the solubility, coatability, and a resist formability, for example, although ethyleneglycol monoethylether acetate has been known, it became quite not employed as a solvent for a resist since an indication of safeness to human bodies, and propyleneglycol monomethylether acetate, etc. have become mainly employed (JP-B-91001659, JP-B-92056973, and JP-B-92049938 Official Gazettes, etc.) as a solvent having a high safeness instead of ethyleneglycol monoethylether acetate. Still further, as solvents having a high safeness, ethyl lactate and methyl-n-amyl ketone, etc. are known other than propyleneglycol monomethylether acetate.

However, when considering the solvents which are thought safe compared to ethyleneglycol monomethylether acetate, there are problems that a resist-formable property and solubility are not sufficient. For example, in the case of propyleneglycol monomethylether acetate, when a resist is coated onto a substrate and a thin layer is formed, a solvent remaining ratio (it is a remaining ratio of the solvents in the thin layer after formation of the thin layer) in the thin layer is high, and there has been a problem of a decline in uniformity of line width and adhesion of a resist layer during developing. It is caused by that although propyleneglycol monomethylether acetate itself is a solvent having a high evaporation speed, when it is employed as a solvent for a resist resin, evaporation proceeds only at a coating surface and a so-called thin layer is formed at the coating surface, whereby, there is apt to become slow evaporation of a solvent which is contained in inside of a coating layer.

Further, it is known that propyleneglycol monomethylether acetate is poorer in solubility to a resin and an initiator compared to ethyleneglycol monomethylether acetate. Still further, JP-A-06324483 Official Gazette discloses a technology that the solubility of a resin and an initiator is improved by using a β-type propyleneglycol monoalkylether acetate.

However, the propyleneglycol-based solvent is still insufficient in the solubility to a resin and an initiator because of the presence of a substituted group at 1,2-position. For that reason, there has been expected a solvent having high safeness and excellent solubility into a resin and an initiator, and in which there is improved a characteristic such as a resist-formable property.

Furthermore, in recent years, a development has shifted from a development by solvents to a development by a diluted aqueous alkali solution in various fields from a reason of environmental problems, resource saving, energy saving, and improvement of workability, etc. Even in a field of molding of a printed circuit board, a resist ink has also shifted from a solvent type to a diluted alkali aqueous solution type by the same reason.

In the printed circuit board, a solder resist resin has been widely employed as a permanent protection thin layer for a circuit board. Heretofore, when a solder resist is formed on a printed circuit board, a thermosetting type resist ink has been printed by a screen printing method and a transferred portion has been cured by heating or an ultraviolet ray. However, there is caused a phenomenon such as bleed, blot, and drip during printing in the screen printing method, and it cannot respond to a shift of a circuit board to high integration. In order to solve the problems, a photographic method has been developed. The photographic method is a method in which a desired pattern is formed by developing after having exposed to light through a film in which a pattern is formed.

However, in recent years, it is shifting to a diluted alkali aqueous solution type which is capable of developing because of a problem of an environmental pollution.

Although there are proposed a variety of resist inks in response to the tendency, since those include various problems that an ink sensitivity is not sufficient, and tackiness, that is, a pressure sensitive adhesive property remains in predrying during which solvents are removed from the inks and, for that reason, predrying conditions must be strengthened in order to completely remove tackiness for the purpose of preventing staining of a negative film during a contact exposure to light, further improvement is desired.

In general, a thermal treatment time of period is extended without elevation of temperature because developability after exposure to light changes to the worse by thermal curing of ink.

In consideration of the problems, there have been proposed various resin materials for a curable resin. In JP-B-91047258 Official Gazette, there are disclosed a reactive acrylic monomer having a terminal carboxylic group, a reactive acrylic monomer in which a (meth)acrylate having a terminal hydroxyl. group is allowed to react with an acid anhydride, and a method for the preparation thereof. In JP-A-60067446 Official Gazette, there is disclosed a method for the preparation of a caprolactone polyester unsaturated monomer in which a radically polymerizable unsaturated monomer having a carboxylic group is allowed to react with ε-caprolactone under the presence of an acidic catalyst.

Accordingly, purpose of the present invention I, instead of a conventional alkali-developable type photocurability in a composition for use as a variety of a picture image-formable material, is to provide a resin composition in which a low storage stability is improved in the case of a composition having a high concentration of carboxylic group and viscosity can be reduced, and to provide an improved photocurable resin composition which can be developed by water or a diluted aqueous alkali solution without an alkali development.

Further, it is to provide a novel thermosetting composition in which the improved photocurable resin composition which is capable of developing by water is added as a component.

Purpose of the present invention II is to provide a photocurable resin composition in which residual carbon substances can be suppressed as low as possible in the molding of PDP separating ribs, and to provide a method for the formation of PDP separating ribs.

Purpose of the present invention III is to provide a liquid-state photoresist resin composition for a printed circuit board in which an amount of residual solvents is decreased in a resist layer during formation of the resist layer together with elevating solubility and safeness in the preparation of a resist composition, and there are improved uniformity of line width and adhesion of the resist layer during development.

Purpose of the present invention IV is to provide a photocurable resin material and a photocurable resin composition which are a well-balanced between an ink sensitivity and a tackfree property, by which a reactive resin can be readily synthesized in the case of employing as a comonomer in a copolymerization reaction with other monomers or in the case of employing as a primary constructing resin.

### Disclosure of the Invention

The present inventors, as a result of an intensive investigation in order to solve the above purposes, have found that those can be solved by providing a composition which is obtained by the addition of a compound for a photopolymerizable reaction to a resin in which a polymerizable unsaturated group is introduced into a resin containing hydroxyl groups, and by providing various novel photocurable resin compositions in which the composition is added to a variety of compositions for a picture image-formable material, and the present invention I has been completed.

Further, the present inventors have found that a photocurable resin composition, in which there is employed a specified resin represented by an acrylic-modified resin of a polyglycerine, is excellent in storage stability and a retentive property of low viscosity, and which can be developed by water or a diluted alkali aqueous solution, and by which the above-described various problems can be solved during the formation of the PDP ink, and the present invention II has been completed.

Still further, the present inventors have found that the above-described problems can be solved by a liquid-state photoresist resin composition for a printed circuit board in which a reaction product of a cycloaliphatic epoxy group-contained unsaturated compound having a specified structure with an acid group-contained unsaturated resin is diluted by a specified organic solvent and a polymerizable vinyl monomer, and the present invention III has been completed.

Furthermore, the present inventors have found that the above-described problems can be solved by a photocurable resin composition containing a monomer composition having a terminal carboxylic group in which a (meth)acrylate having a terminal hydroxyl group is modified by an acid anhydride and, in the (meth)acrylate, 1 mol of a hydroxyethyl(meth)acrylate is modified by less than 1 mol of ε-caprolactone monomer, or by a photocurable resin composition containing a monomer composition having a terminal carboxylic group and, in the monomer composition, less than 1 mol of ε-caprolactone monomer is added to 1 mol of a (meth)acrylic acid, and the present invention IV has been completed.

Subject matter of the present inventions is as follows.

The present invention No. 1 provides a water-developable type photocurable resin composition characterized by containing a resin (I-A) having hydroxyl groups and polymerizable unsaturated groups, a photopolymerizable initiator (B), and a photopolymerizable monomer (I-C).

The present invention No. 2 provides a water-developable type photocurable resin composition as described in the present invention No. 1, in which a hydroxyl group value is 50-800 mgKOH/g in the resin (I-A) having hydroxyl groups and polymerizable unsaturated groups.

The present invention No. 3 provides a water-developable type photocurable resin composition as described in the present invention No. 1 or 2, in which the resin (I-A) having hydroxyl groups and polymerizable unsaturated groups has a weight average molecular weight of 1,000-50,000, a hydroxyl group value is 50-800 mgKOH/g, and a double bond equivalent of 400-2,000.

The present invention No. 4 provides a water-developable type photocurable resin composition as described in any one of the present invention Nos. 1-3, in which a resin (I-A') having an acid value of 1-100 mgKOH/g is employed alone or mixed with the resin (I-A), and the resin (I-A') is obtained by a reaction of the resin (I-A) having hydroxyl groups and polymerizable unsaturated groups with an acid anhydride.

The present invention No. 5 provides a water-developable type photocurable resin composition as described in any one of the present inventions Nos. 1-4, in which the resin having hydroxyl groups is a polyglycerine.

The present invention No. 6 provides a water-developable type photocurable resin composition as described in any one of the present invention Nos. 1-5, in which a pigment is further contained.

The present invention No. 7 provides a photocurable resin composition in which the water-developable type photocurable resin composition as described in any one of the present invention Nos. 1-6 is added to a composition, which is used for any one of uses selected from a liquid resist, a dry film and a pigment resist, for a color filter for a liquid crystal display, or a black-colored matrix.

The present invention No. 8 provides a thermosetting resin composition in which the water-developable type photocurable resin composition as described in any one of the present invention Nos. 1-6 is added to a composition, which is used for any one of uses selected from a liquid resist, a dryfilm, and a pigment resist, a color filter for a liquid crystal display or a black-colored matrix.

The present invention No. 9 provides a water-developable type photocurable resin composition as described in any one of the present invention Nos. 1-3, in which a solvent for dilution (D) is further contained.

The present invention No. 10 provides a water-developable type photocurable resin composition as described in the present invention No. 9, in which there are further contained a glass frit (E), a phosphoric acid compound (F), and ceramics powder (G).

The present invention No. 11 provides a water-developable type photocurable resin composition as described in the present invention No. 9 or 10, in which a black-colored pigment (H) is further contained.

The present invention No. 12 provides a water-developable type photocurable resin composition as described in the present invention No. 10, in which a glass transition point of the glass frit (E) is 300-550 °C.

The present invention No. 13 provides a water-developable type photocurable resin composition as described in the present invention No. 11, in which the black-colored pigment (H) is a metal oxide pigment essentially containing one or more kinds of oxides of Fe, Cr, Mn, and Co, and there is contained the metal oxide pigment in a proportion of 3-100 parts by weight based on 100 parts by weight of the glass frit (E).

The present invention No. 14 provides a water-developable type photocurable resin composition as described in any one of the present invention Nos. 9-13, in which a developer is a diluted alkali aqueous solution.

The present invention No. 15 provides a method for the preparation of a separating rib for a plasma display panel characterized by including a step for the formation of a coating layer by coating a water-developable type photocurable resin composition as described in any one of the present invention Nos. 9-14 on a substrate for a plasma display panel, a step for selectively exposing the coating layer to light by an active beam depending upon a fixed pattern, a step for removing unexposed portions of the coating layer after having developed by water or a diluted alkali aqueous solution, and a step for calcining the coating layer after having developed.

The present invention No. 16 provides a photoresist resin composition for a printed circuit board which comprises formulating an organic solvent (S) and/or a polymerizable vinyl monomer (III-C) with a modified copolymer (III-A1), and the modified copolymer (III-A1) being obtained by an addition reaction of a carboxylic group-contained resin (p) with a cycloaliphatic epoxy group-contained ethylenic unsaturated compound (c), and the carboxylic group-contained resin (p) being obtained by a polymerization of a carboxylic group-contained ethylenic unsaturated compound (a) as an essential monomer component.

The present invention No. 17 provides a photoresist resin composition for a printed circuit board which comprises formulating an organic solvent (S) and/or a polymerizable vinyl monomer (III-C) with a modified copolymer (III-A2), and the modified copolymer (III-A2) being obtained by a reaction of a cycloaliphatic epoxy group-contained resin (q) with a carboxylic group-contained ethylenic unsaturated compound (a), and the resin (q) being obtained by a polymerization of a cycloaliphatic epoxy group-contained ethylenic unsaturated compound (c) as an essential monomer component.

The present invention No. 18 provides a photoresist resin composition for a printed circuit board as described in the present invention No. 16 or 17, in which the organic solvent (S) is glycol ethers.

The present invention No. 19 provides a photoresist resin composition for a printed circuit board as described in the present invention No. 18, in which the glycol ethers are dipropyleneglycol monomethylether.

The present invention No. 20 provides a photoresist resin composition for a printed circuit board as described in the present 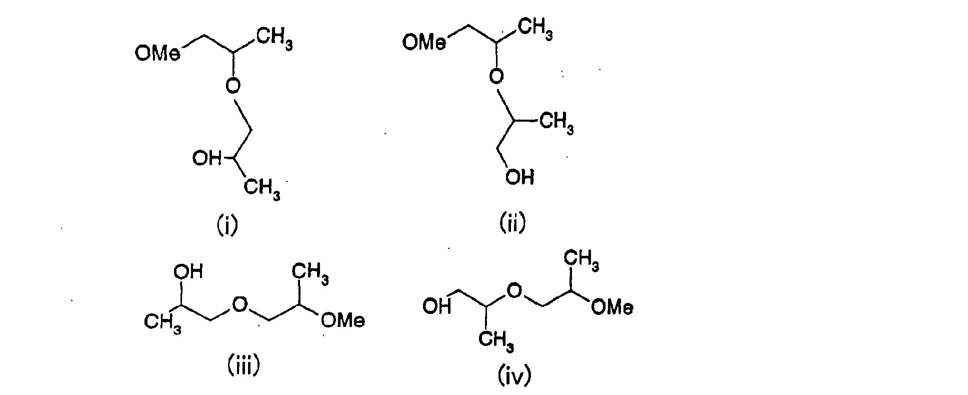 invention No. 19, in which an isomer component (iii) of formula described below in dipropyleneglycol monomethylether is not more than 25% by weight based on total isomers (i) to (iv) of formulae described below in dipropyleneglycol monoethylether.

The present invention No. 21 provides a photocurable resin composition containing a monomer composition (IV-a) having a terminal carboxylic group represented by a formula (1) described below, in which a hydroxy-terminated (meth)acrylate is modified by an acid anhydride and, 0.3 to less than 1 mol of ε-caprolactone is added to 1 mol of a hydroxyalkyl(meth)acrylate on an average.

CH₂=CR¹-COOR²O(COC₅H₁₀O)ₙCOR³-COOH (1)

R¹ represents a hydrogen or a methyl group.
R² represents a hydrocarbon group having a carbon number of 1-5 or an aromatic ring hydrocarbon group.
R³ represents a saturated or unsaturated aliphatic or cycloaliphatic hydrocarbon group or an aromatic ring hydrocarbon group.
n: Average value ranges from 0.3 to less than 1.

The present invention No. 22 provides a photocurable resin composition containing a monomer composition (IV-b) having a terminal carboxylic group represented by formula (2) described below, in which 0.3 to less than 1 mol of ε-caprolactone is added to 1 mol of a (meth)acrylic acid on average.

CH₂=CR¹-CO(OC₅H₁₀CO)ₙ-OH (2)

R¹ represents a hydrogen or a methyl group.
n: Average value ranges from 0.3 to less than 1.

The present invention No. 23 provides a photocurable resin composition containing a compound (IV-c) in which the monomer composition (IV-a) or (IV-b) as described in the present invention No. 21 or 22 is added to a compound having at least two epoxy groups in the molecule.

The present invention No. 24 provides a photocurable resin composition containing a compound (IV-d) in which the compound (IV-c) as described in the present invention No. 23 is further modified by an acid anhydride.

### Best Mode for carrying out the Invention

Hereinafter, modes for carrying out the present inventions are illustrated.

### Modes for carrying out the invention I

### I-1: Resin (I-A) containing hydroxyl groups and polymerizable unsaturated groups

The resin (I-A) component containing hydroxyl groups and polymerizable unsaturated groups which is a primary component for the photocurable resin composition in relation to the present invention I is a resin in which polymerizable unsaturated groups are introduced into a resin having hydroxy groups and, by the introduction thereof, developability is improved, and sensitivity to light and/or heat can be also given, and stability of a coating layer can be also simultaneously given.

Herein, the resin containing hydroxyl groups and polymerizable unsaturated groups is not limited by chemical formulae and a method for the preparation thereof, if it has both functional groups, and there is typically exemplified a resin in which polymerizable unsaturated groups are introduced into a resin having hydroxy groups. Using the typical examples, the resin (I-A) component is illustrated hereinafter.

Herein, as the resin containing hydroxyl groups, there are typically enumerated a polyol compound or an alkylene oxide thereof and an oxide additive such as an aromatic compound having epoxy groups as side chains and, more specifically, there are enumerated a polyglycerine, pentaerythritol, a polyalkylene glycol, a sucrose such as glucose, and trimethylol melamine, etc. which are a polyol compound and, as an oxide compound for addition, there are enumerated ethylene oxide, propylene oxide, butene oxide, and styrene oxide (another name: (1,2-epoxyethyl)benzene), etc.

As the polyols, the polyglycerine is most preferred in view of an excellent affinity to water and thermal decomposition property in high temperatures. Polymerization degree of the polyglycerine is not particularly limited, and it is preferably 5-100 from a viewpoint of being capable of readily obtaining.

As the compound having the polymerizable unsaturated group which can be introduced into the resin containing hydroxyl groups, there are typically enumerated compounds having an acid group which reacts with hydroxyl groups in the resin by transesterification, an ester group which can cause a transesterification reaction or an isocyanate group and a polymerizable unsaturated group, and the groups which allow to connect to hydroxyl groups are not limited to the acid groups and isocyanate groups.

Of the compound having the polymerizable unsaturated group, as the compounds having the acid group, a (meth)acrylic acid (including an ester thereof) is typically exemplified, and there can be also exemplified acids (including an ester thereof) for methyl(meth)acrylate, ethyl(meth)acrylate, propyl(meth)acrylate, butyl(meth)acrylate, pentyl(meth)acrylate, hexyl(meth)acrylate, adamantyl(meth)acrylate, and norbonyl(meth)acrylate, etc.

Further, as a (meth)acrylic acid (including an ester thereof) having hydroxyl group, there are also exemplified 2-hydroxyethyl(meth)acrylate, hydroxypropyl(meth)acrylate, hydroxybutyl(meth)acrylate, a caprolactone-modified 2-hydroxyethyl(meth)acrylate, and hydroxyadamantyl(meth)acrylate, and hydroxynorbonyl(meth)acrylate, etc.

It is to be noted that the above free hydroxyl group may be even modified and, for example, there can be enumerated methoxydiethylene glycol(meth)acrylate, ethoxydiethylene glycol(meth)acrylate, isooctyloxydiethylene glycol(meth)acrylate, phenoxytriethylene glycol(meth)acrylate, methoxytriethylene glycol(meth)acrylate, and methoxypolyethylene glycol(meth)acrylate, etc.

Further, there can be also enumerated 2-acryloyloxy ethylphthalate, 2-acryloyloxyethy hexahydrophthalate, a lactone-modified product thereof (including an ester), an unsaturated monocarboxylic acid, a modified unsaturated monocarboxylic acid having an ether bond, propionyl acid, (iso)crotonic acid, and fumaric acid (also including an ester), etc.

Still further, there can be also employed a modified copolymer in which an epoxy group-contained compound is added to acid groups.

There is typically enumerated a compound having a radically polymerizable unsaturated group and a cycloaliphatic epoxy group in one molecule, and there is exemplified 3,4-epoxycyclohexyl methyl(meth)acrylate.

It is to be noted that there can be also employed glycidylmethacrylate, β-methylglycidylmethacrylate, and allylglycidylmethacrylate.

The above-described various compounds are employed solely or in combination of two or more kinds.

As the above-described compounds which can addition-react with hydroxyl groups in the resin containing hydroxyl groups, there are enumerated compounds in which diisocyanate group which addition-reacts to hydroxyl groups is introduced into acid groups, hydroxyl groups, and phenoxy groups, etc. in the above-described (meth)acrylic acid and an ester thereof, specifically, there can be exemplified isocyanate group-contained (meth)acrylates which can be obtained from a hydroxy(meth)acrylate which is obtained from a (meth)acrylic acid and an alkylene polyvalent alcohol, such as 2-hydroxyethyl(meth)acrylate, tetramethylolmethane tri(meth)acrylate, 4-hydroxybutyl(meth)acrylate, trimethylolpropane tri(meth)acrylate, glycerine(meth)acrylate, glycerine acrylate and methacrylate, pentaerythritol (meth)acrylate, and dipentaerythritol (meth)acrylate, etc. and a diisocyanate compound, for example, isophorone diisocyanate.

In the above-described various components (I-A) in relation to the present invention I, a hydroxyl group value is not particularly limited, and it preferably ranges in 50-800 mgKOH/g.

In the case that the hydroxyl group value is less than 50 mgKOH/g, it becomes difficult to obtain the water-developable type photocurable resin composition and, in the case of exceeding 800 mgKOH/g, there tend to lower a photopolymerizability owing to unsaturated groups introduced and water resistance.

As described hereinabove, it is thought that since the component (I-A) contains an appropriate amount of hydroxyl groups and unsaturated groups, the former contributes to water or alkali developability and the latter contributes to photopolymerizability described hereinafter:

In order to control the hydroxyl group value in the resin containing hydroxyl groups in which a polymerizable unsaturated groups are introduced which is the component (I-A) in relation to the present invention I, it is also effective to simultaneously control an acid value, and there is a method in which there is added an acid anhydride such as acetic anhydride to partially esterify hydroxyl groups. Herein, the acid value preferably ranges in 1-100 mgKOH/g.

In the case that the acid value exceeds 100 mgKOH/g, there is apt to be shown a tendency that developability lowers and water resistance becomes poor. It is to be noted that when the acid value elevates, stability to water or an alkali aqueous solution becomes worse, and an excessive development is caused and, there is shown a tendency that water resistance lowers and an electric property lowers, and it is not regarded that it is preferred for the water or alkali-developable type photopolymerizable resin composition of the present invention I.

It is to be noted that if a resin having an unsaturated groups in which the acid value of the component (I-A) is adjusted to 1-100 mgKOH/g is referred to as the component (I-A'), the component (I-A') inevitably contains a portion corresponding to the original component (I-A) and a portion in which the acid value is controlled, even the component (I-A') alone shows a characteristics of the component (I-A) and, in order to clearly show a characteristics by the component (I-A), the component (I-A) can be also further added to the component (I-A'). By simultaneous use of the both components, the acid value can become also controlled.

### I-2. Photopolymerization initiator (B)

The photopolymerization initiator (B) component is not particularly limited, and there are employed solely or in mixing benzophenone, a ketal (for example, benzylmethylketal), xanthones (for example, diethylxanthone), acetophenone benzyl, benzyldimethyl ketone, benzoin, benzoin methylether, benzoin ethylether, benzoin propylether, dimethoxy acetophenone, dimethoxyphenyl acetophenone, diethoxy acetophenone, and diphenyl disulphide, etc. which are usually employed for photopolymerization.

There is not particularly limited ratio of the photopolymerization initiator (B) component with respect to the component (I-A), and the latter is preferably 0.1-50 parts by weight, and more preferably 1-20 parts by weight based on 100 parts by weight of the former.

In the case of being less than 0.1 part by weight, curing in a deep portion is apt to become insufficient and, in the case of exceeding 50 parts by weight, there is shown a tendency that a transmittance of light becomes poor, and inferiority of curing in a deep portion is caused and alkali resistance becomes poor.

### I-3. Photopolymerizable monomer (I-C)

The photopolymerizable monomer (I-C) in relation to the present invention I is added in order to allow to proceed a curing reaction and, a polyfunctional monomer is preferably employed, and a water or diluted alkali-developable type photocurable resin composition is prepared by being formulated together with the component (I-A) and the photopolymerization initiator (B).

As the photopolymerizable monomer (I-C), there is specifically exemplified a compound having a radically-polymerizable double bond represented by a (meth)acrylate compound and an aromatic vinyl compound such as styrene, and an amide-based compound. As the typical (meth)acrylate, there are employed an alkyl(meth)acrylate such as methyl(meth)acrylate, ethyl(meth)acrylate, propyl(meth)acrylate, butyl(meth)acrylate, pentyl(meth)acrylate, and hexyl(meth)acrylate; a (meth)acrylate having a hydroxyl group such as 2-hydroxyethyl(meth)acrylate, hydroxypropyl(meth)acrylate, hydroxybutyl(meth)acrylate, and a caprolactone-modified 2-hydroxyethyl(meth)acrylate; (meth)acrylates such as methoxydiethylene glycol(meth)acrylate, ethoxydiethylene glycol(meth)acrylate, isooctyloxydiethylene glycol (meth)acrylate, phenoxytriethylene glycol(meth)acrylate, methoxytriethylene glycol(meth)acrylate, and methoxypolyethylene glycol#400(meth)acrylate; a bifunctional (meth)acrylate such as 1,6-hexanediol di(meth)acrylate, and neopentylglycol di(meth)acrylate; and a trifunctional (meth)acrylate such as trimethylolpropane tri(meth)acrylate or an ethylene oxide or propyleneoxide additive thereof, etc.

There is not particularly limited use ratio of the photopolymerizable monomer (C) component with respect to the resin (I-A) component, and the latter is preferably 1-300 parts by weight, and more preferably 1-100 parts by weight based on 100 parts by weight of the former. In the case of being less than 1 part by weight, sensitivity lowers and curability is apt to become insufficient and, in the case of exceeding 300 parts by weight, there is a possibility that a thin layer remains during development and characteristics by the (I-A) component is decreased.

For a photopolymerization reaction in relation to the present invention I, an ultraviolet ray and electron beam, etc. are preferably employed, and it is initiated under the presence of the photopolymerization initiator (B) component.

### I-4. Coloring material

In the composition essentially containing the components (I-A), (B), and (I-C), a coloring material is optionally added and employed. The coloring material includes red, green, and blue ones which are called the three primary colors of light, and black one which constructs a black matrix portion. As the coloring material, dyes and pigments are employed, and the pigments are preferred from a viewpoint of heat resistance and light resistance. As such the pigments, there are inorganic pigments such as barium sulphate, zinc oxide, lead sulphate, titanium oxide, yellow lead, red ocher, cobalt blue, marine blue, chromium oxide, and carbon black, organic dyes such as Benthidine Yellow G, benthidine yellow GR, Solefirst Orange 3GL, Vulcanfirst Orange GC, Pigment Scarlet 3B, Thiokunji Gomaroune, Phtharocyanine Blue, Phtharocyanine Green, Indaneslene Blue, Green Gold, Malakite Green Lake, etc. and the following substances are specifically exemplified.

All pigments are shown by a color index (C.I.) number.
C.I. Yellow-colored pigments 20, 24, 86, 93, 109, 110, 117, 125, 137, 138, 147, 148, 153, 154, 166, 168,
C.I. Orange-colored pigments 36, 43, 51, 55, 59, 61,
C.I. Red-colored pigments 9, 97, 122, 123, 149, 168, 177, 180, 192, 215, 216, 217, 220, 223, 224, 226, 227, 228, 240,
C.I. Violet pigments 19, 23, 29, 30, 37, 40, 50,
C.I. Blue-colored pigments 15, 15:1, 15;4, 15:6, 22, 60, 64,
C.I. Green-colored pigments 7, 36,
C.I. Brown-colored pigments 23, 25, 26,
C.I. Black-colored pigment 7 and titanium black, etc.

In the pigments which are a coloring material, primary particles having not more than 0.3 µm preferably occupy not less than 50% by weight and primary particles having not less than 0.1 µm preferably occupy not more than 5% by weight based on total particles from a viewpoint of transparency and dispersibility of the pigments. In the case that the particles having not more than 0.3 µm is less than 50% by weight with respect to all particles or the particles having not less than 0.1 µm more than 5% by weight with respect to all particles, there becomes worse transparency of a photosensitive colored composition in all cases, and it is not particularly appropriate for uses as a color filter in which transparency is required.

As formulating proportion of the coloring materials with respect to the resin (I-A), the photopolymerizable initiator (B), and the photopolymerizable monomer (I-C), the coloring materials range in 100-1,000 parts by weight, and preferably 100-500 parts by weight based on 100 parts by weight of a solid content of the resin, etc. In the case that the proportion of the coloring materials is less than 100, although characteristics are improved in a color filter, a layer thickness must be thickened in order to obtain a desired optical concentration, resulting in that fine molding becomes difficult.

The photocurable resin composition of the present invention I may optionally contain a thermal polymerization inhibitor and dispersants for the pigments as other additives.

By the appropriate addition of the dispersants for the pigments, dispersibility of the pigments is improved. As such the dispersants, there are employed derivatives from a variety of surface active agents and organic coloring materials. Since such the dispersants are excellent in dispersibility of the pigments, and those have a large effect for preventing reaggregation of the pigments after having dispersed, there can be obtained a color filter having an excellent transparency. Specifically, there are Acetamine 24, Acetamine 86, and Coatamine 86P Conc (all of those are manufactured by Kao, Ltd.) which are a cationic-based one, Demol P, Demol EP, Homogenol M-8, Homogenol L-18, Homogenol L-95, and Homogenol L-100 (all of those are manufactured by Kao, Ltd.) which are an anionic-based one. Further, there are Emulgen A-60, Leodol SP-L10, Leodol SP-O10, Emazol L-10H, and Emazol S-20 (all of those are manufactured by Kao, Ltd.) which are a nonionic-based one.

Still further, although specifications are different depending upon the organic coloring materials, the derivatives from the organic coloring materials are particularly effective. As the organic coloring materials which are a starting substance, there are an azo-based one, a phthalocyanine-based one, a quinaklidone-based one, an anthraquinone-based one, a perylene-based one, a perinone-based one, a thioindigo-based one, a dioxadine-based one, an isoindolinone-based one, a quinophthalone-based one, a triphenylmethane-based one, and a metal complex salt-based one, etc.

There is a derivative in which substituted groups are introduced into the organic coloring materials which is effective for dispersing the pigments. As the substituted groups, for example, hydroxyl group, carboxylic group, sulphonic acid group, carbon amide group, sulphone amide group, or any one of the substituted groups represented by a general formula or a formula described below. There is employed a derivative having at least one kind of substituted groups selected from the groups. It is to be noted that in the starting organic coloring materials for the pigments and dispersants for the pigments, identical ones are employed in combination, however, it does not always require that those are consistent with each other.

-CH₂-X-A

(X: an oxygen or a sulphur atom,
A: an aryl group)

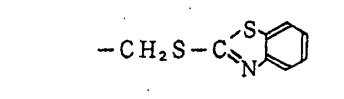

-CH₂OX-NR¹R²

(X: an alkylene group,
R¹ and R²: a hydrogen atom or an alkyl group, or a heterocyclic ring containing at least one nitrogen atom, in which R¹ and R² are combined)

-CH₂NR¹R²

(R¹: a hydrogen atom, an alkyl group, or an aryl group,
R²: an alkyl group, an aryl group, or a heterocyclic ring containing at least one nitrogen atom, in which R¹ and R² are combined)

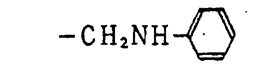

-SO₂NR¹-A-NR²R³

(R¹: a hydrogen atom and an alkyl group,
A: an alkylene group,
R²: an alkyl group, an alkoxyalkyl group, or a cycloalkyl group,
R³: a hydrogen atom, a cycloalkyl group, or a heterocyclic ring containing at least one nitrogen atom, in which R¹ and R² are combined)

### I-5. Other additives

In addition, as additives, there can be optionally contained a thermal polymerization inhibitor, a surface active agent, a photoabsorbent, a thixotropic agent, and dyes, etc. Further, thermoplastic resins and thermosetting resins, etc. can be also formulated.

### I-6. Method for the formation of a thin layer

The photocurable resin composition of the present invention I is coated on a substrate as a thin layer, and it can be cured by photo-irradiation (including an electron beam, etc.).

As the method for the formation of a thin layer, there are enumerated a spraying method, a brushing method, a roll coating method, a curtain coating method, a screen coating method, an electro-deposition coating method, and an electrostatic coating method, etc. Curing is preferably conducted under an atmosphere of an inert gas, and it can be also conducted under an atmosphere of air.

Water or diluted alkali-developable photocurable resin composition primarily containing the (I-A), (B), and (I-C) according to the present invention I is employed by adding to a composition which is used for a liquid-state resist, a dry film, a pigment resist for a color filter or a black matrix, and in the case of a development of a photocurable picture image-formable layer by photoirradiation, an uncured resin can be removed by water.

Further, it is employed by adding the composition which is used for a liquid-state resist, a dry film, a pigment resist for a color filter or a black matrix and, after having patterned, a thermosetting picture image can be formed by heating.

### Mode for carrying out the Invention II

In the photocurable resin composition of the present invention II, in addition to the above-described components (I-A), (B), (I-C), a solvent for dilution (D) is employed.

### II-1. Components (I-A), (B), and (I-C)

The components (I-A), (B), (I-C) which construct the photocurable resin composition in relation to the present invention II are quite likewise employed as in the modes for carrying out in the above-described present invention I, and illustration is omitted.

### II-2. Solvent for dilution (D)

The solvent for dilution (D) is employed for the formation of a paste by diluting the composition and, whereby, a coating step becomes easily conducted, and then, a thin layer is formed by drying and, whereby, a contact exposure can become conducted.

Use amount of the solvent for dilution (D) is very smaller compared to conventional use amount of an organic solvent in developing, and the solvent for dilution (D) is removed by drying and, since it is not moved in a developing step, environmental problems can be largely improved.

The solvent for dilution (D) is formulated in an appropriate proportion of amount, so that a desired paste viscosity is obtained depending upon a coating method for the paste, and it is not particularly limited. In usual, it is preferably employed in 5-500 parts by weight with respect to 100 parts by weight of total of the respective components (I-A), (B), and (I-C).

As specific examples of the solvent for dilution (D), there are enumerated ketones such as methylethylketone, and cyclohexanone; aromatic hydrocarbons such as toluene, xylene, and teramethyl benzene; glycol ethers such as cellosolve, methyl cellosolve, carbitol, methylcarbitol, butylcarbitol, propyleneglycol monomethylether, dipropyleneglycol monomethylether, dipropyleneglycol monoethylether, and triethyleneglycol monoethylether; acetates such as ethyl acetate, butyl acetate, cellosolve acetate, butylcellosolve acetate, carbitol acetate, butylcarbitol acetate, and propyleneglycol monomethylether acetate; alcohols such as ethanol, propanol, ethylene glycol, and propylene glycol; aliphatic hydrocarbons such as octane and decane; and petroleum-based solvents such as a petroleum ether, petroleum naphtha, hydrogenated petroleum naphtha, and solvent naphtha, etc., and those can be employed solely or on combination of two or more kinds.

Further, an acrylic-based and silicone-based defoaming agent and a leveling agent can be also added to the solvent for dilution (D). Specifically, there are BYK series manufactured by Vickchemie Japan, Ltd., etc.

### II-3. Additives (E)-(G) components

The above-described composition essentially containing the above-described components (I-A), (B), (I-C), and (D) may optionally contain a glass frit (E), a phosphoric acid compound (F), and a ceramics powder (G).

The components are particularly useful in the case that PDP ribs, etc. are obtained by a contact exposure to light after preparation of a thin layer through a coating step by pasting using the composition primarily containing the (I-A) to (D) and by developing with water or a diluted alkali solution, and photocuring is accelerated and strength of the ribs after calcining can be elevated by the addition of the components (E) to (G).

The glass frit (E) is added to the composition containing the above-described (I-A) to (D) as rib materials in the formation of the ribs, and it is preferably employed together with the (F) and (G).

Composition (% by weight) in the glass frit (E) is preferably PbO: 60-80%, B₂O₃: 1-20%, SiO₂: 1-15%, and Al₂O₃: 1-10% (total thereof is 100%).

Further, average particle diameter is preferably not more than 20 µ m, and particularly preferably not more than 5 µm from a viewpoint of dissolution.

Still further, in the glass frit (E), there is preferred a substance having a volume expansion coefficient α of glass (300 °C) of 70x10⁻⁷-90x10⁻⁷/°C and a glass transition point of 300-550°C.

On the other hand, the phosphoric compound (F) is employed together with the glass frit (E) and ceramics powder (G) in order to improve viscosity stability (storage stability) of the composition in relation to the present invention II, and use amount of the phosphoric compound (F) is preferably 0.1-5 parts by weight with respect to 100 parts by weight of the glass frit (E).

Herein, as the phosphoric compound (F), there are enumerated phosphoric acid, phosphite acid, mono(2-methacryloyloxyethyl)acid phosphate, mono(2-acryloyloxyethyl)acid phosphate, di(2-methacryloyloxyethyl)acid phosphate, and di(2-acryloyloxyethyl)acid phosphate, etc., and those can be solely or in combination of two or more kinds.

As the ceramics powder (G), there can be employed ceramics powder such as alumina, mulite, coajelite, zircon, zirconia, and lead titanate, etc.

### II-4. Black colored pigment (H)

Further, in the photocurable resin composition primarily containing the above-described (I-A) to (D) in relation to the present invention II or the photocurable resin composition in which there are further contained the above-described respective components (E) to (G), a black colored pigment (H) is optionally added and employed. The black colored pigment (H), as described hereinabove, is added in order to prevent halation in exposing to light such as an ultraviolet ray, and it is preferably added in 3-100 parts by weight with respect to 100 parts by weight of the glass flit (E) in order to improve a blackness degree of the ribs after having calcined in the preparation of the PDP ribs as described hereinafter.

As the black colored pigment (H), there can be preferably employed a metal oxide primarily containing one or more kinds of Fe, Cr, Mn, and Co oxides.

Average diameter of the black colored pigment (H) is preferably not more than 20µm, and more preferably not more than 5 µ m from a viewpoint of image dissolution.

### II-5. Other additives

In addition, as additives, there can be optionally contained a thermal polymerization inhibitor, a surface active agent, a photoabsorbent, a thixotropic agent, and dyes. Further, thermoplastic resins and thermosetting resins can be also formulated.

### II-6. Method for the preparation of PDP ribs

Hereinafter, there is illustrated a method for the preparation of PDP ribs in which there is employed the photocurable resin composition in relation to the present invention II.

The photocurable resin composition including the above-described various modes is coated on a glass-made substrate for a plasma display panel by an appropriate coating method such as a screen printing method and a method using a barcoater and blade coater.

Subsequently, the solvent for dilution is evaporated in a hot air circulating drying furnace, etc. in order to attain a finger touch dryness.

After having coated as described hereinabove, a step for exposing to light and a step for developing are once or repeatedly conducted, and calcination is conducted after formation of separating rib patterns having a desired thickness and aspect ratio.

As the step for exposing to light, there can be employed a contact exposure and noncontact exposure method using a photomask having a fixed pattern for exposing, and the contact exposure is more preferred from image dissolution.

As circumstances for exposing to light, a vacuum or nitrogen atmosphere is preferred. As resources for exposing to light, there are employed a halogen lamp, a high pressure mercury lamp, a laser light, a metal halide lamp, a black lamp, and an electrodeless lamp which can discharge an active beam.

In the step for developing, a spraying method and immersion method, etc. are employed. As a developer, in addition to water itself, a diluted alkali can be employed, and there are preferably employed an aqueous solution containing 0.1-10% by weight of alkali metal compound such as sodium hydroxide, potassium hydroxide, sodium carbonate, potassium carbonate, and sodium silicate, a diluted aqueous solution of an amine such as monoethanol amine, diethanolamine, and triethanolamine. If it is a developer by which the resin (I-A) in the composition is saponified and dissolved by the developer, and uncured portions (unexposed portions) are removed, it is not limited to the above-exemplified developers.

Further, washing by water and neutralization by acids are preferably conducted in order to remove unnecessary developer after having developed.

In the calcination step, a substrate after development is thermally-treated at 450-600 °C under an atmosphere of air or nitrogen to form separating rib patterns. At that time, there is preferably combined a step in which organic substances such as resins are burned and removed by heating at 400-500 °C in air.

By the use of water or diluted alkali-developable photocurable resin composition in relation to the present invention II, high precision separating rib patterns can be stably formed on a large-sized substrate for a PDP without any problems of deterioration in working circumstances and with an excellent yield and good productivity.

### Modes for carrying out the Invention III

### III-1. Modified copolymer (III-A)

The photoresist resin composition for a printed circuit board (hereinafter, referred to as photoresist resin composition) of the present invention III is comprised formulating the modified copolymer (III-A) and an organic solvent and/or a polymerizable vinyl monomer.

The modified copolymer (III-A) is a modified copolymer (III-A1), a modified copolymer (III-A2), or a mixture thereof.

The modified copolymer (III-A1) is obtained by an addition reaction of a carboxylic group-contained resin (p) with a cycloaliphatic epoxy group-contained ethylenic unsaturated compound (c). The resin (p) is obtained by polymerization of a carboxylic group-contained ethylenic unsaturated compound (a) which is an essential monomer component and other optional ethylenic unsaturated compound (b) other than the compound (a).

The modified copolymer (III-A2) is obtained by an addition reaction of a cycloaliphatic epoxy group-contained resin (q) with a carboxylic group-contained ethylenic unsaturated compound (a), and the resin (q) is obtained by a polymerization of a cycloaliphatic epoxy group-contained ethylenic unsaturated compound (c) which is an essential monomer component, and optionally, the above-described component (a) and/or component (b).

First of all, the modified copolymer (III-A1) will be illustrated.

### III-1-1. Modified copolymer (III-A1)

The carboxylic group-contained ethylenic unsaturated compound (a) is a compound having an unsaturated group and at least one carboxylic group in the molecule. Specifically, in addition to (meth)acrylic acid, there can be exemplified a compound represented by a general formula (III-1) described below. The compound represented by the general formula (III-1) can be prepared by allowing to react an aliphatic polycarboxylic acid or an acid anhydride thereof represented by X(COOH)₂ with a compound obtained by an addition of ε-caprolactone to hydroxyethyl(meth)acrylate.

CH₂=CR¹COOCH₂CH₂O[CO(CH₂)₅O]ₙCOXCOOH (III-1)

(in the formula, n is an integer of 1-10, and R¹ is a hydrogen atom or a methyl group, and X represents an alkylene group)

In the general formula (III-1), X is preferably an alkylene group having a carbon number of 1-3.

As the polycarboxylic acid or the acid anhydride thereof to be employed, there is enumerated a polycarboxylic acid such as a dicarboxylic acid, a tricarboxylic acid, and a tetracarboxylic acid, or a mono or diacid anhydride thereof, and preferably, it is the dicarboxylic anhydride.

Specifically, there are enumerated phthalic anhydride, tetrahydrophthalic anhydride, maleic anhydride, trimellitic anhydride, pyromellitic anhydride, succinic anhydride, and glutaric anhydride, etc.

As the other ethylenic unsaturated compound (b), there are exemplified methyl(meth)acrylate, butyl(meth)acrylate, benzyl(meth)acrylate, cyclohexyl(meth)acrylate, isobonyl(meth)acrylate, and hydroxyethyl(meth)acrylate; esters of a compound represented by a general formula (2) described below; styrenes such as styrene and hydroxystyrene; maleic anhydride, and maleic acid imide, etc.

CH₂=CR²COOCH₂CH₂O[CO(CH₂)₅O]ₙH (III-2)

(in the formula, n is an integer of 1-10, and R² is a hydrogen atom or a methyl group)

The compound represented by the general formula (III-2) can be obtained by an addition of ε-caprolactone to hydroxyethyl(meth)acrylate.

The component (b) can be changed depending upon uses, and a (meth)acrylate is usually employed.

Constructing molar ratio of the component (a) with respect to the component (b) is usually 3:7-7:3 and, in the range, there can be obtained a photoresist resin composition having an excellent weatherability and adhesion.

A vinyl polymerization reaction of the component (a) itself or a vinyl copolymerization reaction of the component (a) with the component (b) is conducted according to a common method and, the carboxylic group-contained resin (p) is obtained.

The carboxylic group-contained resin (p) obtained as described hereinabove produces the modified copolymer (III-A1) by an addition reaction of the cycloaliphatic epoxy group-contained ethylenic unsaturated compound (c) to carboxylic groups which are a side chain thereof.

The cycloaliphatic epoxy group-contained ethylenic unsaturated compound (c) is an unsaturated group-contained epoxy compound having at least one kind of a cycloaliphatic structure in the molecule and, for example, there is enumerated a compound represented by formulae described below.

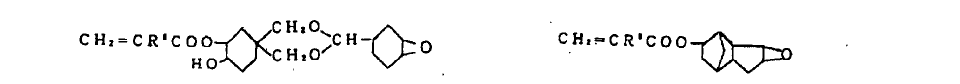

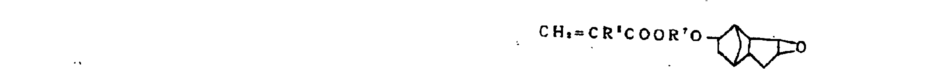

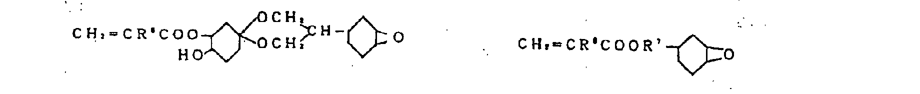

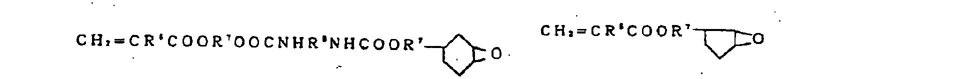

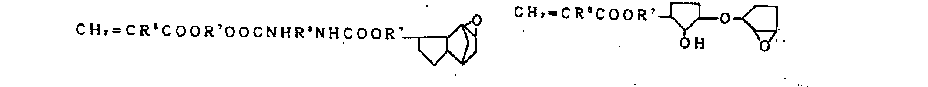

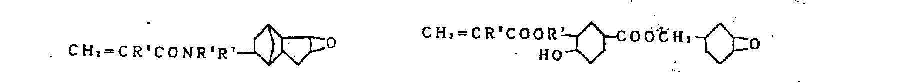

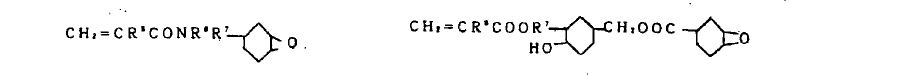

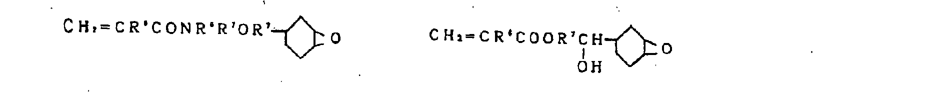

In the respective formulae, R⁶ is a hydrogen atom or a methyl group, and R⁷ is a bivalent aliphatic saturated hydrocarbon group having a carbon number 1-6, and R⁸ is a divalent hydrocarbon group having a carbon number 1-10.

Of those, preferably, there are an enumerated 3,4-epoxycyclohexyl methyl(meth)acrylate and a caprolactone-modified compound thereof. Those may be formulated even solely or in combination of two or more kinds.

By formulating the above-described compounds having a cycloaliphatic structure as described hereinabove, water resistance and acid resistance are improved in the composition.

Use amount of the epoxy group-contained unsaturated compound (c) is 0.5-4.0 mol, particularly 1.0-3.5 mol as an amount of double bonds contained in 1 kg of the modified copolymer (III-A1). In the case of being less than 0.5 mol, a sufficient curability is not occasionally obtained and, in the case of being more than 4.0 mol, storage stability is occasionally poor.

Addition reaction of the component (c) to the resin (p) is preferably conducted at a temperature of not more than 130 °C, and particularly, 90-130°C. In the case of less than 90 °C, a practically sufficient reaction rate is not occasionally obtained and, in the case of more than 130 °C, double bonds produce crosslinking by a thermally radical polymerization, and gels are occasionally produced.

In the addition reaction, an organic solvent (S) is preferably employed. The solvent (S), if it dissolves raw materials and a product, is not particularly limited. For example, there are enumerated glycols such as ethyleneglycol, propyleneglycol, and dipropyleneglycol, glycol ethers such as methyl cellosolve, propyleneglycol monomethylether, and dipropyleneglycol monomethylether, glycol esters such as ethyleneglycol diacetate and propyleneglycol monomethylether acetate, and a mixed solvent thereof. The solvent (S) is preferably the glycol ether, and dipropyleneglycol monomethylether is particularly preferred.

The present inventors, as a result of an intensive investigation relating to the solvent (S), have found that there is obtained a photoresist composition having an excellent physical properties (a remaining ratio of the solvents in the thin layer, uniformity of line width, and adhesion of a resist layer during development, etc.), particularly, adhesion during development in the case that content of the isomer component (iii) is not more than 25% by weight, preferably not more than 20% by weight, and particularly preferably not more than 15% by weight with respect to the amount of total isomers (i)-(iv) using dipropyleneglycol monomethylether which is the glycol ethers.

Concentration of the modified copolymer (III-A1) in the solvent (S) for the reaction is preferably 20-80% by weight. In the case that the concentration of the copolymer is less than 20% by weight, a sufficient reaction rate is not occasionally obtained and, in the case of not less than 80% by weight, viscosity in reaction solution becomes too high, and it is afraid that agitation becomes insufficient.

In order to obtain a sufficient reaction rate, the addition reaction is preferably conducted using a catalyst.

As the catalyst, there can be employed phosphines such as triphenylphosphine and tributylphosphine, amines such as triethyl amine and dimethylbenzyl amine, and sulphides such as dimethyl sulphide, etc., and the phosphines are preferred from a viewpoint of the reaction rate.

The catalyst is usually employed in an amount of 0.01-10% by weight, and preferably 0.5-5.0% by weight with respect to the epoxy group-contained ethylenic unsaturated compound (c) having cycloaliphatic structure. In the case that the amount of the catalyst is less than 0.01% by weight, a sufficient reaction rate is not occasionally obtained and, in the case that more than 10% by weight is added, it is afraid that it adversely affects to various physical properties in a resin produced.

In order to prevent production of gels in the reaction, the addition reaction is preferably conducted under the presence of a polymerization inhibitor such as hydroquinone, hydroquinone monomethylether, and phenothiazine. Amount of the polymerization inhibitor is preferably 1-10000 ppm with respect to a total reaction liquid. In the case that the mount of the polymerization inhibitor is less than 1 ppm in the total reaction liquid, a sufficient effect as the polymerization inhibitor is not occasionally obtained and, in the case of exceeding 10000 ppm, it is afraid that it adversely affects to various physical properties in a resin produced. From the same reason, the addition reaction is preferably conducted under an atmosphere of a molecular state oxygen-contained gas. Concentration of oxygen may be a concentration in which an explosive mixture is not produced in a reaction system, and it is usually adjusted to 1-7%.

Hereinafter, the modified copolymer (III-A2) will be illustrated.

### III-1-2. Modified copolymer (III-A2)

The cycloaliphatic epoxy group-contained resin (q) to be employed for the modified copolymer (III-A2) is obtained by a sole polymerization of a cycloaliphatic epoxy group-contained unsaturated compound (c) which is an essential monomer component or a copolymerization of the component (c) with the above-described component (a) or component (b), or a mixture thereof.

As the above-described component (c), component (a), component (b), the same ones can be employed as in the item of the above-described resin (p).

In the case that the component (c) is allowed to copolymerize with the component (a), those are selected as being adjusted to an acid value described hereinafter to be required for the modified copolymer (III-A2) and an amount of double bonds illustrated in the modified copolymer (III-A1).

Epoxy equivalent in the resin (q) obtained ranges in 250-2,000, and preferably 280-1,000.

Use amount of the component (c) is 0.5-4.0 mol, particularly 1.0-3.5 mol as an amount of double bonds contained in 1 kg of the modified copolymer (III-A2). In the case of being less than 0.5 mol, a sufficient curability is not occasionally obtained and, in the case of being more than 4.0 mol, storage stability is occasionally poor.

Preparation of the modified copolymer (III-A2) is conducted by introducing unsaturated groups into the resin obtained by allowing to addition-react the cycloaliphatic epoxy group-contained resin (q) with the component (a).

Conditions in the addition reaction of the resin (q) with the component (a), a catalyst, a solvent, and a polymerization inhibitor, etc. are the same as in the case of the preparation of the modified copolymer (III-A1).

In the liquid-state photoresist resin composition for a printed circuit board to be employed in the present invention, there can be appropriately formulated a polymerizable vinyl monomer (a reactive diluent) (III-C) having at least one (meth)acrylic group depending upon uses and characteristics of a coating layer to be required.

### III-2. Reactive diluent (III-C)

As the reactive diluent (a polymerizable vinyl monomer) (III-C), if it dissolves the modified copolymer (III-A), it is not particularly limited. For example, there can be exemplified an alkyl or cycloalkyl(meth)acrylate such as isobonyl(meth)acrylate, cyclohexyl(meth)acrylate, and octyl(meth)acrylate; a hydroxyalkyl(meth)acrylate such as 2-hydroxyethyl(meth)acrylate, and 3-hydroxypropyl(meth)acrylate; a mono or di(meth)acrylate of glycols such as a mono or di(meth)acrylate of ethyleneglycol, a (meth)acrylate of methoxyethylene glycol, a mono or di(meth)acrylate of tetraethylene glycol, and a mono or di(meth)acrylate of tripropyleneglycol; an epoxy group-contained (meth)acrylate such as 3,4-epoxycyclohexyl methyl(meth)acrylate and glycidyl(meth)acrylate; a (meth)acrylate of a polyol or an alkylene oxide additive such as glycerine di(meth)acrylate, trimethylolpropane tri(meth)acrylate, pentaerythritol tri or tetra(meth)acrylate, and dipentaerythritol hexa(meth)acrylate, etc. Of those, there is preferred a compound having an ignition point of not.less than 100 °C from a viewpoint of insuring safeness in a preparation step.

The component (III-C) is formulated in a proportion of 1-150 parts by weight with respect to 100 parts by weight of the component (III-A).

In the photoresist resin composition of the present invention, there may be added the polymerization initiator (B) which is employed for curing by an ultraviolet ray, etc.

### III-3. Polymerization initiator (B)

The photopolymerization initiator (B) to be employed is not particularly limited, and there can be employed benzoins, acetophenones, ketals, benzophenones, xanthones, and peroxides, etc. which are publicly-known and commonly used.

The photopolymerization initiator is preferably formulated in a proportion of 1-10% by weight in the photoresist resin composition.

In the photoresist resin composition of the present invention III, optionally, there can be formulated a reactive resin such as an epoxy resin, fillers such as barium sulphate, silicone oxide, talc, clay, and calcium carbonate, a coloring pigment such as Phthalocyanine Green, Crystal Violet, titanium oxide and carbon black, a variety of additives such as adhesion agent and a leveling agent, and an polymerization inhibitor such as hydroquinone, hydroquinone monomethylether, and phenothiazine.

The photoresist resin composition of the present invention III is also useful as a constructing component for a coating, ink, and adhesive, etc.

### Modes for carrying out the invention IV

### IV-1. Monomer composition (IV-a) having a terminal carboxylic group

### IV-1-1. Hydroxyalkyl(meth)acrylate

As the hydroxyalkyl(meth)acrylate to be employed in the invention IV, if it is an alkyl(meth)acrylate having hydroxyl group at terminal, it is not particularly limited, and there are enumerated 2-hydroxyethyl(meth)acrylate, 2-hydroxypropyl(meth)acrylate, 3-hydroxypropyl(meth)acrylate, 1,4-butyleneglycol mono(meth)acrylate, hydroxycyclohexyl (meth)acrylate, hydroxyadamantyl(meth)acrylate, and a mixture thereof. Of those, 2-hydroxyethyl(meth)acrylate is preferably employed from a viewpoint of a balance between sensitivity and tackiness.

Further, the (meth)acrylic acid to be employed in the present invention IV includes acrylic acid, methacrylic acid, or a mixture thereof.

### IV-1-2. Synthesis of a lactone-modified hydroxyl(meth)acrylate

In the present invention IV, ε-caprolactone is employed for producing a hydroxy-terminated (meth)acrylate or a carboxyl group-terminated (meth)acrylate by a ring opening addition of polymerization of *ε*-caprolactone to the above-described hydroxyalkyl(meth)acrylate or (meth)acrylic acid. Of the lactone monomer composition, ε-caprolactone is employed from a viewpoint of stably obtaining.

ε-caprolactone is added in a range of from 0.3 to less than 1 mol, and preferably 0.4 to 0.8 mol on an average with respect to 1 mol of the hydroxyalkyl(meth)acrylate.

Further, ε-caprolactone is added in a range of from 0.3 to less than 1 mol, and preferably 0.4 to 0.9 mol on an average with respect to 1 mol of the (meth)acrylic acid. In both cases, when an addition amount of lactone becomes large, although a curing reactivity and flexibility are improved, there is caused a problem that hardness and acid resistance occasionally lower.

Still further, in addition to ε-caprolactone, there may be simultaneously employed a cyclic lactone such as trimethyl caprolactone and valerolactone within an amount in which ε-caprolactone becomes a primary component.

In the ring opening addition polymerization, there can be employed catalysts such as a stannous halide and monobutyltin tris-3-ethylhexanate, stannous octoate, and dibutyltin diraulate, etc.

Of those, the use of monobutyltin tris-2-ethylhexanate is very excellent and preferred because discoloration is decreased and an esterification reaction is reduced, and concentration of catalyst can be increased and, reaction time of period is shortened.

Amount of the catalyst to be employed is 1-1000 ppm, and preferably 10-500 ppm in reactant.

In the ring opening addition polymerization of ε - caprolactone to the hydroxyalkyl(meth)acrylate, reaction temperature is 80-150 °C, and preferably 100-140 °C. In the case of being lower than 80 °C, reaction is slow and, in the case of being higher than 150 °C, (meth)acrylic groups cause thermal polymerization, resulting in that gelation is dangerously caused. In a reaction system, a polymerization inhibitor is preferably added. As the polymerization inhibitor, hydroquinone, hydroquinone monomethylether, and phenothiazine, etc. are employed in a range of 0.01-1%, and preferably 0.03-0.5% with respect to reactant.

In the reaction system, since radical polymerization is apt to be caused by streaming an inert gas such as nitrogen, streaming a mixed gas containing oxygen or air is useful for preventing the thermal polymerization of the reactant.

In the hydroxy-terminated (meth)acrylate obtained, content of residual lactone is 0-10% by weight, content of the residual hydroxyalkyl(meth)acrylate is 20-50% by weight, content of di(meth)acrylate which is a by-product is 2% by weight or less, and content of by-products which are produced by a Michael addition, polymerization of the (meth)acrylate, esterification reaction, other side reactions is not more than 10% by weight, content of catalysts is less than 1000 ppm, and content of the polymerization inhibitor is not more than 1%.

### IV-1-3. Monomer composition (IV-a) having a terminal carboxylic group

The monomer composition (IV-a) having a terminal carboxylic group is obtained by modification of the hydroxy-terminated (meth)acrylate obtained with an acid anhydride. A resin composition containing the monomer composition (IV-a) having a terminal carboxylic group [hereinafter, occasionally abbreviated as "the monomer composition (IV-a)"] has a photocurability.

As the acid anhydride, for example, there are employed succinic anhydride, maleic anhydride, phthalic anhydride, tetrahydrophthalic anhydride, tetrahydrosuccinic anhydride, hexahydrophthalic anhydride, trimellitic anhydride, hettic anhydride, hymic anhydride, adipic anhydride, azelaic anhydride, sebasic anhydride, and a substituted derivative thereof.

In a modifying reaction by the acid anhydride, the acid anhydride is added to a reaction liquid containing the hydroxy-terminated (meth)acrylate obtained in advance in preferably 0.8-1.2 mol equivalent, and more preferably 0.8-1.0 mol equivalent with respect to 1 mol of the hydroxy-terminated (meth)acrylate, and the reaction is preferably conducted at 50-150 °C, and more preferably 50-140 °C while agitating.

On the other hand, the ring opening addition polymerization reaction of ε-caprolactone to (meth)acrylic acid is likewise conducted as well as in the method of the ring opening addition polymerization reaction of ε-caprolactone to the hydroxyalkyl(meth)acrylate. In the ring opening addition polymerization, reaction temperature is 50-150 °C, and preferably 100-140 °C. From a viewpoint of stably obtaining a product, it is preferred to adjust the reaction temperature in the range. Thus-obtained resin composition containing the (meth)acrylic monomer composition (IV-b) having a terminal carboxylic group [hereinafter, occasionally abbreviated as "the monomer composition (IV-b)"] has a photocurability.

As a preferred embodiment of the present invention IV, there can be exemplified a photocurable resin composition containing a compound (IV-c) [hereinafter, occasionally abbreviated as "the compound (IV-c)"] obtained by addition of the monomer compositions (IV-a) or (IV-b) to a compound having at least two epoxy groups in the molecule.

As the compound having at least two epoxy groups in the molecule (hereinafter, occasionally abbreviated as "the epoxy compound"), if it is a compound having the above conditions, it is not limited. For example, there can be enumerated a cresol-novolak type epoxy resin (having an epoxy equivalent of 220, and manufactured by Yuka Shell Epoxy, Ltd.), a phenol-novolak type epoxy resin (Epikote 154 manufactured by Yuka Shell Epoxy, Ltd.), and a DPP novolak type epoxy resin (Epikote 157S65 manufactured by Yuka Shell Epoxy, Ltd.), etc., a glycidylether type, a glycidylester type, a glycidyl amine type, a cycloaliphatic type, a bisphenol A type, a bisphenol F type, a brominated bisphenol A type, a hydrogenated bisphenol A type, a bisphenol S type, a bisphenol AF type, a naphthalene type, a biphenyl type, a fluorene type, etc, a block copolymer of an aromatic block having a vinyl group with a conjugated diene compound, and a polymer or a copolymer of a compound having an epoxy group and a polymerizable unsaturated group, etc.

In the reaction for obtaining the compound (IV-c) by the addition reaction of the monomer composition (IV-a) or the monomer composition (IV-b) to the epoxy compound, reaction ratio of (the epoxy compound) with respect to (the monomer composition (IV-a) or the monomer composition (IV-b)) is 1.0/0.5-1.0/1.2, and preferably 1.0/0.8-1.0/1.1 (molar equivalent ratio of an epoxy compound/monomer composition). In the case that amount of the epoxy compound is too large, storage stability unpreferably lowers in the compound (IV-c) obtained. Further, in the case that proportion of the epoxy compound is too small, unreacted monomer becomes unpreferably large. Reaction temperature ranges in preferably 80-150 °C, and more preferably 100-140 °C.

As a preferred embodiment of the present invention IV, there can be exemplified a compound (IV-d) in which the compound (IV-c) obtained hereinabove is further modified by an acid anhydride. As the acid anhydride to be employed herein, the above-described acid anhydride can be employed. Use amount of the acid anhydride with respect to the compound (IV-c) is 0.8-1.2 mol equivalent, and preferably 0.8-1.0 mol equivalent with respect to 1 mol of the monomer composition (IV-a) and/or the monomer composition (IV-b).

Reaction for modification by the acid anhydride is preferably conducted at conditions of temperature of 50-150 °C.

Thus-obtained resin composition containing the compound (IV-d) is a resin composition having a photocurability.

In the photocurable resin composition of the present invention IV containing the monomer composition (IV-a), the monomer composition (IV-b), the compound (IV-c), and the compound (IV-d), within a range in which inherent characteristics is not deteriorated, respectively, there can be added a photopolymerization initiator, a monomer or oligomer for dilution, an epoxy compound, and other additives, etc. according to uses.

As the photopolymerization initiator, for example, there are employed benzophenone, acetophenone benzyl, benzyldimethyl ketone, benzoin, benzoin methylether, benzoin ethylether, benzoin isopropylether, dimethoxy acetophenone, dimethoxyphenyl acetophenone, diethoxy acetophenone, and diphenyl disulphide, etc., solely or in mixing.

The photopolymerization initiator may also contain a synergistic agent for accelerating a conversion of absorbed photoenergy to a polymerization initiating radical group, for example, a tertiary amine.

In the case that the curable resin composition of the present invention is cured by irradiation of an electron beam, the addition of the initiator is not always required.

As the monomer or oligomer for dilution, for example, there are enumerated a compound having a radically polymerizable double bond represented by a (meth)acrylate compound, an aromatic vinyl compound such as styrene, and an amide-based unsaturated compound.

Typical (meth)acrylates are as follows.

There are exemplified an alkyl(meth)acrylate such as methyl(meth)acrylate, ethyl(meth)acrylate, propyl(meth)acrylate, butyl(meth)acrylate, pentyl(meth)acrylate, and hexyl(meth)acrylate; a (meth)acrylate having a hydroxyl group such as 2-hydroxyethyl(meth)acrylate, hydroxypropyl (meth)acrylate, hydroxybutyl(meth)acrylate, and a caprolactone-modified 2-hydroxyethyl(meth)acrylate; (meth)acrylates such as methoxydiethylene glycol(meth)acrylate, ethoxydiethylene glycol(meth)acrylate, isooctyloxydiethylene glycol(meth)acrylate, phenoxytriethylene glycol(meth)acrylate, methoxytriethylene glycol(meth)acrylate, and methoxypolyethylene glycol#400-(meth)acrylate; a bifunctional (meth)acrylate such as 1,6-hexanediol di(meth)acrylate and neopentylglycol di(meth)acrylate; and a trifunctional (meth)acrylate such as trimethylolpropane tri(meth)acrylate, etc.

As a polymerizable prepolymer, for example, there are enumerated (meth)acrylates of a polyester polyol, (meth)acrylates of a polyether polyol, an additive of a polyepoxy compound with a (meth)acrylic acid, and a resin in which a hydroxy(meth)acrylate is introduced into a polyol through a polyioscyanate, etc.

As the epoxy compound, for example, there can be enumerated an epoxy resin containing unsaturated groups such as an epoxidized polybutadiene and an epoxidized butadiene-styrene block copolymer.

As commercially supplied products thereof, there are Epolead PB and ESBS manufactured by Daicel Chemical Industries, Ltd.

Further, cycloaliphatic epoxy resins can be enumerated. As commercially supplied products thereof, there are Celloxide 2021 and EHPE manufactured by Daicel Chemical Industries, Ltd.; Epomic VG-3101 manufactured by Mitsui Kagaku, Ltd.; E-103IS manufactured by Yuka Shell Epoxy, Ltd.; TETRAD-X and TETRAD-C manufactured by Mitsubishi Gas Kagaku, Ltd.; and EPB-13 and EPB-27 manufactured by Nihon Soda, Ltd., etc.

Still further, copolymerized type epoxy resins can be enumerated. As commercially supplied products thereof, for example, there are CP-50M and CP-50S manufactured by Nihon Yushi, Ltd. which are a copolymer of glycidylmethacrylate with styrene and methylmethacrylate, or a copolymer of glycidylmethacrylate with cyclohexylmaleimide, etc.

In addition, there can be enumerated an epoxidized resin having a specified structure, etc.

Furthermore, there can be enumerated a novolak type epoxy resin which is obtained by a reaction of, for example, novolaks with epichlorohydrin or methylepichlorohydrin, and the novolaks are obtained by allowing to react phenols such as phenol, cresol, a halogenated phenol, and an alkyl phenol with formaldehyde under the presence of an acidic catalyst.

As commercially supplied products thereof, there are EOCN-103, EOCN-104S, EOCN-1020, EOCN-1027, EPPN-201, and BREN-S manufactured by Nihon Kayaku, Ltd.; DEN-431 and DEN-439 manufactured by Dow Chemical, Ltd.; and N-73 and VH-4150 manufactured by Dainippon Ink Kagaku, Ltd., etc.

There are enumerated a bisphenol type epoxy resin which is obtained by, for example, bisphenols such as bisphenol A, bisphenol F, bisphenol S, and tetrabromo bisphenol A with epicholorohydrin and an epoxy resin which is obtained by a reaction of a condensate of diglycidylether of bisphenol A and the bisphenols with epicholorohydrin. As commercially supplied products thereof, there are Epikote 1004 and Epikote 1002 manufactured by Yuka Shell, Ltd. and DER-330 and DER-337 manufactured by Dow Chemical, Ltd., etc.

There can be enumerated epoxy resins, etc. obtained by a reaction of trisphenolmethane or triscresolmethane, etc with epichlorohydrine and/or methylepichlorohydrine. As commercially supplied products thereof, there are EPPN-501 EPPN-502 manufactured by Nihon Kayaku, Ltd.

In addition, there can be also employed tris(2,3-epoxypropyl)isocyanurate and biphenyldiglycidylether, etc.

The epoxy resins may be employed solely or in mixing. The epoxy resins are added in a necessary amount, for example, 0-100 parts by weight with respect to 100 parts by weight of the photocurable resin composition. In the case that an amount of the epoxy resins are more than 100 parts by weight, there is reduced characteristics in the photocurable resin composition of the present invention.

As the other additives, there can be optionally formulated a thermal polymerization inhibitor, a surface active agent, a photoabsorbent, a thixotropic agent, various ceramics powder such as a glass frit, alumina, mulite, koajelite, zircon, zirconia, lead titanate, a metal oxide, dyes and pigments, etc. Further, thermoplastic resins and thermosetting resins can be also formulated.

The photocurable resin composition of the present invention IV can be utilized in a wide range such as a resin composition for a resist ink in a printed circuit board, a resin composition for insulating between layers for buildup, a color filter, a black matrix, a protecting layer, a material for forming a liquid crystal spacer and ITO (an indium-tin oxide-made conductive substrate), a material for forming ribs in an PDP (a plasma display panel) and FED (a field emission display), a material for forming a conductive body, a fluorescent material, a coating, a coating material, and a printing ink, etc.

### Examples

Hereinafter, although the present invention is illustrated by Examples, the present invention is not limited to the Examples.

It is to be noted that "part" and "%" are based on the weight not so far as being not particularly described.

### Examples in relation to the present invention I

### (Synthesis Example I-1)

A 2L (liter) separable flask equipped with an agitator, a thermometer, a reflux condenser, a dropping funnel, and a tube for supplying a mixed gas was charged with 387 g of isophorone diisocyanate (manufactured by Daicel Chemical Industries, Ltd., it is abbreviated as IPDI) as a diisocyanate component and 20 ppm (with respect to total amount) of di-n-butyltin dilaurate as a catalyst component. After having elevated a temperature to 70 °C, there was dropped 155 g of 2-hydroxyethylacrylate (abbreviated as HEA) which is a monomer for introducing a polymerizable unsaturated group over 2 hours, followed by aging until an NCO value attains to 12.3%. After that, 358 g of a polyglycerine (abbreviated as PGL-10, which is manufactured by Daicel Chemical Industries, Ltd., and which has a hydroxyl group vale of 878 mgKOH/g) which is a resin having hydroxyl groups was dissolved in 200 g of N,N-dimethylacetamide (referred to as DMAC, which is manufactured by Daicel Chemical Industries, Ltd.) which is a solvent to obtain a curable resin solution (AI-1) having a hydroxyl group value of 300 mgKOH/g, a double bond equivalent (g weight of a resin per 1 mol of an unsaturated group) of 600, and a weight average molecular weight of 10,000.

### (Synthesis Example I-2)

A 2L separable flask equipped with an agitator, a thermometer, a reflux condenser, a dropping funnel, and a tube for supplying a mixed gas was charged with 192 g of isophorone diisocyanate (the same as in the Synthesis Example I-1) and 20 ppm (with respect to total amount) of di-n-butyltin dilaurate (the same as in the Synthesis Example I-1). After having elevated a temperature to 70 °C, there was dropped 265 g of tetramethylol methane triacrylate (abbreviated as A-TMM, which is manufactured by Shinnakamura Kagaku, Ltd.) for introducing a polymerizable unsaturated group over 2 hours, followed by aging until an NCO value attains to 7.9%. After that, 343 g of a polyglycerine (the same as in the Synthesis Example I-1) was dissolved in 200 g of N,N-dimethylacetamide (the same as in the Synthesis Example I-1) to obtain a curable resin solution (AI-2) having a hydroxyl group value of 314 mgKOH/g, a double bond equivalent 300, and a weight average molecular weight of 13,000.

### (Synthesis Example I-3)

A 2L separable flask equipped with an agitator, a thermometer, a reflux condenser, a dropping funnel, and a tube for supplying a mixed gas was charged with 287 g of isophorone diisocyanate (the same as in the Synthesis Example I-1) and 20 ppm (with respect to total amount) of di-n-butyltin dilaurate. After having elevated a temperature to 70°C, there was dropped 192 g of 4-hydroxybutylacrylate for introducing a polymerizable unsaturated group over 2 hours, followed by aging until an NCO value attains to 11.3%. After that, 320 g of a polyglycerine (the same as in the Synthesis Example I-1) was dissolved in 200 g of N,N-dimethylacetamide (the same as in the Synthesis Example I-1) to obtain a curable resin solution (AI-3) having a hydroxyl group value of 258 mgKOH/g, a double bond equivalent 600, and a weight average molecular weight of 10,000.

### (Synthesis Example I-4)

A 2L separable flask equipped with an agitator, a thermometer, a reflux condenser, a dropping funnel, and a tube for supplying a mixed gas was charged with 200 g of N,N-dimethylacetamide (the same as in the Synthesis Example I-1) and 524 g of a polyglycerine (the same as in the Synthesis Example I-1). After having elevated a temperature to 70 °C, there was dropped 265 g of isocyanate ethylmethacrylate (manufactured by Dow, Ltd., referred to as IEM) which is a compound for introducing a polymerizable unsaturated group over 2 hours, followed by aging until an NCO value attains to 0 to obtain a curable resin solution (AI-4) having a hydroxyl group value of 450 mgKOH/g, a double bond equivalent 450, and a weight average molecular weight of 8,000.

### (Synthesis Example I-5)

A 2L separable flask equipped with an agitator, a thermometer, a reflux condenser, a dropping funnel, and a tube for supplying a mixed gas was charged with 239 g of isophorone diisocyanate (the same as in the Synthesis Example I-1) and 20 ppm (the same as in the Synthesis Example I-1) of di-n-butyltin dilaurate. After having elevated a temperature to 70 °C, there was dropped 129 g of 2-hydroxyethylacrylate (HEA) for introducing a polymerizable unsaturated group over 2 hours, followed by aging until an NCO value attains to 12.3%. After that, 116.5 g of a polyglycerine (the same as in the Synthesis Example I-1) was dissolved in 200 g of N,N-dimethylacetamide (the same as in the Synthesis Example I-1), subsequently, 15.2 g of tetrahydrophthalic anhydride was added to obtain a curable resin solution (AI-5) having a hydroxyl group value of 69 mgKOH/g, an acid value of 11 mgKOH/g, a double bond equivalent of 450, and a weight average molecular weight of 15,000.

### (Synthesis Example I-6)

A 2L separable flask equipped with an agitator, a thermometer, a reflux condenser, a dropping funnel, and a tube for supplying a mixed gas was charged with 250 g of dipropyleneglycol monomethylether (abbreviated as MFDG, which is manufactured by Nihon Nyukazai, Ltd.). After having elevated a temperature to 95 °C, there was dropped 77 g of methacrylic acid, 98 g of methylmethacrylate, 325 g of 2-hydroxyethylmethacrylate, 325 g of MFDG, and 250 g of MFDG and 40 g of t-butyl-peroxy-2-ethylhexanoate (referred to as Perbutyl O, manufactured by Nihon Yushi, Ltd.) over 3 hours. After dropwise addition, aging was conducted for 3 hours to obtain a curable resin solution (AI-6) having an acid value of 100 mgKOH/g, a hydroxyl group value of 280 mgKOH/g, and a weight average molecular weight of 15,000.

### (Examples I-1 to I-5 and Comparative Example I-1)

There were mixed respective 100 parts by weight (solid components) of the resin solutions AI-1 to AI-6, 20 parts by weight of an adduct which is a photopolymerizable monomer in which 3 mol of ethylene oxide is added to 1 mol of trimethylolpropane triacrylate, 7 parts by weight of benzylmethyl ketal which is a photopolymerizable initiator, 2 parts by weight of diethyl thioxanthone which is employed for the same purpose, and 5 parts by weight of silica, followed by kneading with a three-rolls kneader to obtain a viscous ink composition.

The ink composition obtained hereinabove was coated using a barcoater in thickness of 20 µm on a substrate on which a pattern is formed, and it was dried at 80 °C for 20 minutes with an air-circulating dryer. After that, a noncontact exposure to light was conducted using a negative film with an irradiation dose of 1,000 mJ/ cm². After that, developability was checked using pure water.

Dissolution degree in patterns obtained was checked using an optical microscope.

Developability, sensitivity, and stability of a coating layer were checked in relation to the resin solutions of the component (I-A), respectively. Results are shown in Table I-1.

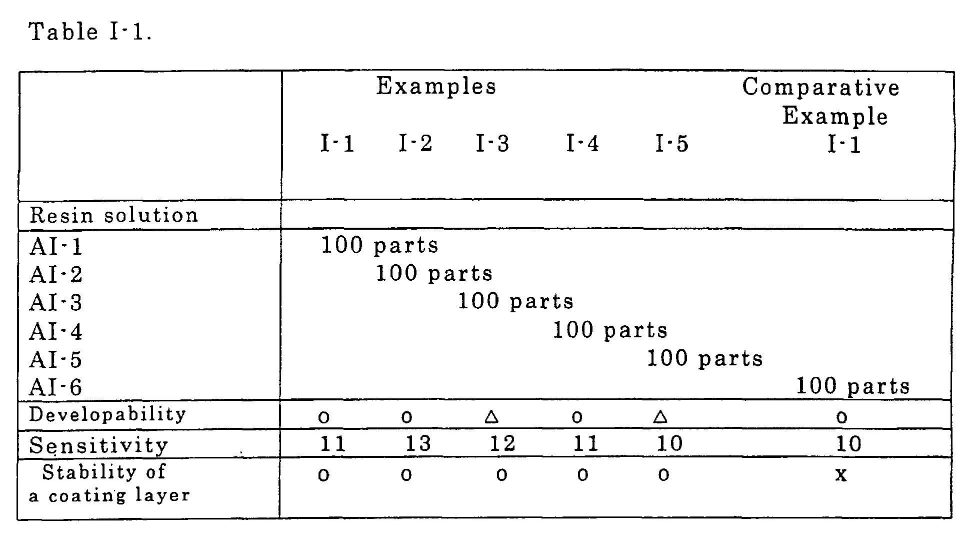

Hereinafter, there are illustrated evaluation methods in the Examples, etc. described above.

### (Developability)

A coating layer was developed at 30 °C and a spraying pressure of 2 kg/cm² using a pure water, and it was evaluated according to the following evaluation rules.
- o:: being capable of developing within 30 seconds.
- △:: being capable of developing within 30-120 seconds.
- x:: being incapable of developing within 30 seconds.

### (Sensitivity)

It was evaluated using a 21-stages step tablet by Stoeffer, Ltd.

### (Stability of a coating layer)

After the completion of development by water, a change in a cured coating layer was observed while successively continuing a developing operation, and evaluated according to the following rules.
- o:: Whitening was not caused for 30 seconds after the completion of development in a coating layer surface.
- △:: Whitening was not caused for 15 seconds after the completion of development in a coating layer surface.
- x:: Whitening was observed at the completion of development in a coating layer surface.

As being clear from results shown in the Table I-1, it was confirmed that the ink composition employed in the Examples is capable of developing by water, and a cured coating layer is also excellent in water resistance.

In the resin composition of the present invention I, polymerizable unsaturated groups are introduced into a resin having hydroxyl groups and it is capable of being developed by water and, since it has polymerizable unsaturated bonds as side chains, water resistance is improved in a cured coating layer and, moreover, pH control in a developer became unnecessary, which has been problematic in an alkali development.

### Examples in relation to the invention II

### (Synthesis Example II-1)

A 2L (liter) separable flask equipped with an agitator, a thermometer, a reflux condenser, a dropping funnel, and a tube for supplying a mixed gas was charged with 154 g of isophorone diisocyanate (IPDI manufactured by Daicel Chemical Industries, Ltd.) as an isocyanate component and 20 ppm of di-n-butyltin dilaurate as a catalyst with respect to IPDI. After having elevated a temperature to 70 °C, there was dropped 83 g of 2-hydroxyethylacrylate (named HEA) having a polymerizable unsaturated group over 2 hours, followed by conducting aging until an NCO value attains to 12.3%.

After that, 263 g of a polyglycerine (a trade name PGL-10, which is manufactured by Daicel Chemical Industries, Ltd., and which has a hydroxyl group vale of 878 mgKOH/g) which is a resin having hydroxyl groups was dissolved in 500 g of N,N-dimethylacetamide (a trade name DMAC, which is manufactured by Daicel Chemical Industries, Ltd.) to obtain a curable resin solution (AII-1) having a hydroxyl group value of 381 mgKOH/g, a double bond equivalent (g weight of a resin per 1 mol of an unsaturated group) of 700, and a weight average molecular weight of 10,000.

### (Synthesis Example II-2)

A 2L separable flask equipped with an agitator, a thermometer, a reflux condenser, a dropping funnel, and a tube for supplying a mixed gas was charged with 600 g of N,N-dimethylacetamide (the same DMAC as in the Synthesis Example II-1) as a solvent and 427 g of a polyglycerine (the same PGL-10 as in the Synthesis Example II-1) which is a resin having hydroxyl groups. After having elevated a temperature to 70 °C, there was dropped 173 g of m-isopropenyl- α, α-dimethylbenzyl isocyanate (TMI manufactured by Mitsui Cytech, Ltd.) over 2 hours, followed by conducting aging until an NCO value attains to 0 to obtain a curable resin solution (AII-2) having a hydroxyl group value of 544 mgKOH/g, a double bond equivalent of 700, and a weight average molecular weight of 8,000.

### (Synthesis Example II-3)

A 2L separable flask equipped with an agitator, a thermometer, a reflux condenser, a dropping funnel, and a tube for supplying a mixed gas was charged with 500 g of N,N-dimethylacetamide (the same DMAC as in the Synthesis Example II-1) as a solvent and 389 g of a polyglycerine (the same PGL-10 as in the Synthesis Example II-1) which is a resin having hydroxyl groups. After having elevated a temperature to 70 °C, there was dropped 111 g of isocyanate ethylmethacrylate (IEM manufactured by Dow, Ltd.) which is an isocyanate component over 2 hours, followed by aging until an NCO value attains to 0 to obtain a curable resin solution (AII-3) having a hydroxyl group value of 603 mgKOH/g, a double bond equivalent of 700, and a weight average molecular weight of 7,000.

### (Synthesis Example II-4)

A 2L separable flask equipped with an agitator, a thermometer, a reflux condenser, a dropping funnel, and a tube for supplying a mixed gas was charged with 192 g of isophorone diisocyanate (the same IPDI as in the Synthesis Example II-1) as an isocyanate component and 20 ppm of di-n-butyltin dilaurate as a catalyst with respect to IPDI. After having elevated a temperature to 70 °C, there was dropped 265 g of tetramethylol methane triacrylate (A-TMM manufactured by Shin-Nakamura Kagaku, Ltd.) having a polymerizable unsaturated group over 2 hours, followed by aging until an NCO value attains to 7.9%. After that, 343 g of a polyglycerine (the same PGL-10 as in the Synthesis Example II-1) which is a resin having hydroxyl groups was dissolved in 200 g of N,N-dimethylacetamide (the same DMAC as in the Synthesis Example II-1) to obtain a curable resin solution (AII-4) having a hydroxyl group value of 314 mgKOH/g, a double bond equivalent 300, and a weight average molecular weight of 13,000.

### (Synthesis Example II-5)

A 2L separable flask equipped with an agitator, a thermometer, a reflux condenser, a dropping funnel, and a tube for supplying a mixed gas was charged with 239 g of isophorone diisocyanate (the same IPDI as in the Synthesis Example II-1) as an isocyanate component and 20 ppm of di-n-butyltin dilaurate as a catalyst with respect to IPDI. After having elevated a temperature to 70 °C, there was dropped 129 g of 2-hydroxyethylacrylate (HEA) having a polymerizable unsaturated group over 2 hours, followed by conducting aging until an NCO value attains to 12.3%. After that, 116.5 g of a polyglycerine (the same PGL-10 as in the Synthesis Example II-1) which is a resin having hydroxyl groups was dissolved in 500 g of N,N-dimethylacetamide (the same DMAC as in the Synthesis Example II-1). Subsequently, 15.2 g of tetrahydrophthalic anhydride was added to obtain a curable resin solution (AII-5) having a hydroxyl group value of 69 mgKOH/g, an acid value of 11 mgKOH/g, a double bond equivalent of 450, and a weight average molecular weight of 15,000.

### (Synthesis Example II-6)

A 2L separable flask equipped with an agitator, a thermometer, a reflux condenser, a dropping funnel, and a tube for supplying a mixed gas was charged with 250 g of dipropyleneglycol monomethylether (a trade name MFDG manufactured by Nihon Nyukazai, Ltd.). After having elevated a temperature to 110 °C, there was dropped 179 g of methacrylic acid, 177 g of methylmethacrylate, 230 g of the MFDG and 21.7 g of t-butyl-peroxy-2-ethylhexanoate (a trade name Perbutyl O manufactured by Nihon Yushi, Ltd.) over 3 hours. After dropwise addition, aging was conducted for 3 hours to obtain a trunk polymer having carboxylic groups.

Subsequently, there were added 164 g of glycidyl methacrylate (a trade name of Blemmer G manufactured by Nihon Yushi, Ltd.), 1.7 g of triphenylphosphine, 1.0 g of methylhydroquinone into a solution of the trunk polymer, followed by allowing to react at 100 °C for 10 hours. Reaction was conducted under a mixed atmosphere of air/nitrogen to obtain a curable resin solution (AII-6) having an acid value of 100 mgKOH/g, a double bond equivalent of 450, and a weight average molecular weight of 16,500.

Using the resin solutions obtained in the Synthesis Examples II-1 to II-6, pentaerythritol triacrylate which is a photopolymerizable monomer,
2-benzyl-2-dimethylamino-1-(4-morpholinophenyl)-butane-1-on which is a photopolymerization initiator, and dipropyleneglycol monomethylether which is a solvent for dilution, and by adding additives described in the Table II-1 described below, formulation was conducted in composition ratio described in the Table, followed by agitating with an agitator and kneading with a three-rolls kneader to obtain a composition.

Glass frit employed herein contains PbO of 60%, B₂O₃ of 20%, SiO₂ of 15%, Al₂O₃ of 5% (composition ratio), and it has thermal expansion coefficient α (300 °C)=70x10⁻⁷/°C, a glass transition point of 445 °C, an average particle diameter of 2.5 µ m, and an average particle diameter of a black-colored pigment of 1 µ m.

### (Examples II-1 to II-5 and Comparative Example II-1)

Of the above-described compositions, the resin solutions AII-1 to AII-5 were employed in the Examples, and the resin solution AII-6 was employed in the Comparative Example.

In relation to respective compositions, a storage stability (viscosity stability after 1 hour and 24 hours) was evaluated and, separating ribs for a plasma display panel were formed on a glass substrate, and sensitivity (Stoeffer-made 21-stages step tablet), developability (direct visual observation of the substrate and visual observation by transmitted light from back surface of the substrate after having developed), a line shape after having calcined was evaluated using the respective compositions.

The separating ribs were formed according to the following arrangements.

First of all, a composition at a period of 1 hour after having been prepared was coated all over the surface of a glass substrate using a polyester screen having 300 mesh and, subsequently, a thin layer was formed by drying at 90 °C for 20 minutes using a hot air circulating drying furnace. Subsequently, exposure to light was conducted using a negative film having a lattice-shaped pattern by which a line width of 50 µm is formed and using an irradiating source of a metal halide lamp so that integrated irradiating quantity on the composition becomes 200 mJ/cm². After that, development was conducted using 1 wt% Na₂CO₃ aqueous solution having a liquid temperature of 30 °C, and washed by water. Subsequently, it was maintained at 450 °C for 30 minutes in air, and temperature was further elevated, followed by calcining at 530 °C for 30 minutes in air to prepare a board.

In relation to the board obtained, respective evaluation items were evaluated according to evaluation rules, and results are shown in Table II-1.

**Table II-1**

| Composition component | Examples | | | | | Comparative Examples |
|---|---|---|---|---|---|---|
| | II-1 | II-2 | II-3 | II-4 | II-5 | II-1 |
| | Composition ratio | | | | | |
| Resin | AII-1 100 | AII-2 100 | AII-3 100 | AII-4 100 | AII-5 100 | AII-6 100 |
| PETA | 50 | 50 | 50 | 50 | 50 | 50 |
| BDMB | 10 | 10 | 10 | 10 | 10 | 10 |
| MFDG | 100 | 100 | 100 | 100 | 100 | 100 |
| BCP | 30 | 30 | 30 | 30 | 30 | 30 |
| Glass frit | 450 | 450 | 450 | 450 | 450 | 450 |
| Phosphite acid | 6 | 6 | 6 | 6 | 6 | 6 |
| Alumina | 250 | 250 | 250 | 250 | 250 | 250 |

| Evaluation items | Evaluation results | | | | | |
|---|---|---|---|---|---|---|
| Sensitivity | 5 | 3 | 4 | 7 | 6 | 4 |
| Storage stability | | | | | | |
| (1 hour) | o | o | o | o | o | o |
| (24 hour) | o | o | o | o | o | x |
| Developability | o | o | o | o | o | x |
| Line shape after having calcined | o | o | o | o | o | △ |
| In the Table II-1, abbreviations are as follows. | | | | | | |
| PETA: Pentaerythritol triacrylate | | | | | | |
| BDMB: 2-benzyl-2-dimethylamino-1-(4-morpholinophenyl)-butane-1-on | | | | | | |
| MFDG: Dipropyleneglycol monomethylether | | | | | | |
| BCP: Black-colored pigment | | | | | | |

### [Evaluation Rule]

(1) Sensitivity: It was evaluated using a 21-stages step tablet by Stoeffer, Ltd.
(2) Storage stability:
   (1 hour)
   - o:: Viscosity increase is less than 10%.
   - △:: Viscosity increase is not less than 10% to less than 30%.
   - x:: Viscosity increase is not less than 30%.
   (24 hour)
   - o:: Viscosity increase is less than 30%.
   - △:: Viscosity increase is not less than 30% to less than 50%.
   - x:: Viscosity increase is not less than 50%.
(3) Developability:
   o: It means a condition that lines are stably remained, and paste is not remained between lines.
   △: It means a condition that less than 10% of lines are peeled based on the whole or undeveloped portions (that is, an unclear portion is observed by transmitted light) between lines slightly are observed.
   x: It means a condition that not less than 10% of lines are peeled based on the whole or undeveloped portions between lines are observed.
(4) Line shape after having been calcined:
   o: It means a condition that warp and peeling are not observed in a cross sectional shape of ribs.
   △: It means a condition that a warp slightly is observed in a cross sectional shape of ribs, and less than 10% of peeling is observed.
   x: It means a condition that a warp exists in a cross sectional shape of ribs, and not less than 10% of peeling is observed.

As being clear from the above-described illustration, a high precision rib pattern can become stably formed on a large-sized substrate for a PDP without a problem of a change to the worse in working circumstances by the use of the components (I-A) to (D) and, optionally, by the use of the components (E) to (H), with a high yield and stable productivity.

### Examples in relation to the present invention III

### (Example III-1)

A separable flask having internal capacity of 5 liter equipped with an agitator, a thermometer, a reflux condenser, a dropping funnel, and a tube for supplying nitrogen was charged with 600 g of dipropyleneglycol monomethylether having content of 12% of the isomer (iii) and 12 g of t-butyl-peroxy-2-ethylhexanoate. After having elevated a temperature to 90 °C, there was dropped a mixed solution composed of 390 g of methacrylic acid, 230 g of benzylmethacrylate, 670 g of dipropyleneglycol monomethylether having content of 12% of the isomer (iii), and 10 g of azobisdimethyl valeronitrile over 3 hours, followed by further conducting aging for 6 hours to obtain a solution of a resin having carboxylic groups. Reaction was conducted under nitrogen streaming.

Subsequently, there were added 420 g of 3,4-epoxycyclohexyl methlacrylate ("Cyclomer A200" manufactured by Daicel Chemical Industries, Ltd.), 8 g of triphenylphosphine, 2.4 g of hydroquinone monomethylether, and 96 g of a dipropyleneglycol monomethylether having content of 12% of the isomer (iii) to the solution of a resin obtained, followed by allowing to react at 100 °C for 20 hours to obtain a solution of a modified copolymer. Reaction was conducted while streaming a mixed gas composed of 7% by volume of oxygen and 93% by volume of nitrogen.

### (Comparative Example III-1)

The same procedures were followed as in the Example III-1, except that a dipropyleneglycol monomethylether having content of 36% of the isomer (iii) was employed as a solvent to prepare a solution of a modified copolymer.

### (Formation of a coating layer)

50 parts by weight of trimethylolpropane triacrylate and 2 parts by weight of "Irgacure 907" which is an initiator manufactured by Ciba Geigy, AG. were formulated with 50 parts by weight of the solution of the modified copolymer prepared in the Example III-1 and Comparative Example III-1 to prepare a curable resin composition (a photoresist resin composition).

The curable resin composition was coated on a Bondelite steel plate PB-144 (manufactured by Nihon Test Panel, Ltd.) in a coating layer thickness of 10 m, and exposed to light with a high pressure mercury lamp (irradiation quantity of 1000 mJ/ cm²), followed by thermally treating at 150 °C for 20 minutes.

The coating layers obtained above were evaluated in evaluation items (1)-(2) described below. Results are shown in Table III-1.

### (Evaluation items)

### (1) Adhesion

After having immersed in boiled water for 1 hour, an evaluation was conducted according to JIS K5400 "Cross-hatched test". Relationship between conditions of defects produced in the test and evaluation marks is as follows.
10 marks: Each cut is fine and both sides are smooth. Intersection point of cuts and cross of each square are not peeled.
8 marks: Intersection point of cuts is slightly peeled and cross of each square is not peeled, and area of deficit portions is within 5% with respect to area of total squares.
6 marks: Both sides of cuts are peeled, and area of deficit portions
   is of 5-15% with respect to area of total squares.
4 marks: Peeling width by cuts is wide, and area of deficit portions is of 15-35% with respect to area of total squares.
2 marks: Peeling width by cuts is wider than in the 4 marks, and area of deficit portions is of 35-65% with respect to area of total squares.
0 mark: Area of peeling portions is not less than 65% with respect
   to area of total squares.

### (2) Hardness of a coating layer

In measurement, Fischer Scope H-100 (manufactured by Fischer Instruments) which is a micro hardness tester was employed.

Conditions in the measurement are as follows. Pushing force was set up to 50 mN for 6 seconds using a Vickers bob (a square bob having a top angle of 136° ). Measurements were conducted in repeated times of n=5, and clearly erroneous data were omitted, and average value was measured.

**Table III-1**

| | (1) | (2) | (3) | (4) | (5) |
|---|---|---|---|---|---|
| Example III-1 | 12 | 42.4 | 56,100 | 8 marks | 255 |
| Comparative Example III-1 | 36 | 42.5 | 55,900 | 4 marks | 251 |

In the Table III-1, numbers (1) to (5) are as follows.
- (1): Content (%) of the isomer (iii) in dipropyleneglycol monomethylether
- (2): Solid Content (%)
- (3): Viscosity of resin (cps/25°C)
- (4): Adhesion
- (5): Hardness of a coating layer Universal hardness (N/mm²)

Ratio of the isomer in the solvent also contributes to physical properties of a coating layer from the photoresist resin and it was confirmed that there is obtained a photoresist having an excellent adhesion and hardness of a coating layer by the use of dipropyleneglycol monomethylether having a small amount of the isomer (iii).

By the present invention III, a coating layer of a photoresist is excellent in physical properties such as adhesion and hardness of a coating layer, and it is practically useful as a liquid-state etching and solder photoresist resin composition for the preparation of a printed circuit board.

### Examples in relation to the present invention IV

Abbreviation of resins employed in the Examples are as follows.

### EHPE: a cycloaliphatic solid epoxy resin (an epoxy equivalent of 173, manufactured by Daicel Chemical Industries, Ltd.)

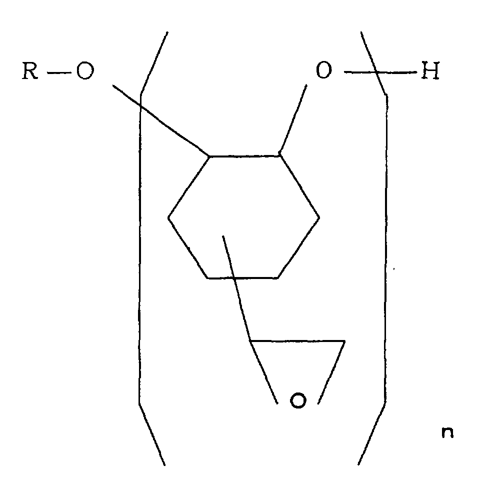

### (Synthesis Examples of a resin IV-A)

### (Synthesis Example IV-1)

First of all, as described below, there was synthesized a carboxylic group containing - teminated acrylate (a) in which an acrylate containing 0.5 mol of ε-caprolactone on an average is modified by maleic anhydride.

A four-necked flask having equipped with a tube for introducing air, a thermometer, a condenser, and an agitation device was charged with 504 parts 2-hydroxyethylacrylate (2-HEA), 248 parts of ε-caprolactone, 0.368 part of hydroquinone monomethylether, 0.148 part of monobutyltin tris-2-ethylhexanate, followed by allowing to react at 100 °C for 7 hours while streaming air to obtain an adduct containing 0.5 mol of ε-caprolactone on an average. Subsequently, 405 parts of maleic anhydride was added and reaction was conducted at 90 °C for approximately 8 hours to obtain a desired compound.

Subsequently, a 2L separable flask equipped with an agitator, a thermometer, a reflux condenser, a dropping funnel, and a tube for introducing nitrogen was charged with 400 parts of carbitol acetate and 180 parts of the EHPE, followed by thermally melting.

Subsequently, there were added 0.5 part of methylhydroquinone which is a polymerization inhibitor and 2 parts of triphenyl phosphine which is a catalyst for reaction. Mixture was heated to 100 °C, and there was dropped 270 parts (0.95 equivalent) of the carboxylic group containing - teminated acrylate (a) in which 0.5 piece of ε-caprolactone is added on an average and modified by maleic anhydride. After having aged for 10 hours, it was cooled to 80 °C, and 144 parts of tetrahydrophthalic anhydride was added, and aged for 8 hours, followed by cooling to obtain a desired resin (AIV-1).

In the resin obtained, nonvolatile components were 60%, and an acid value of solid components was 88 mgKOH/g.

### (Synthesis Example IV-2)

Subsequently, a 2L separable flask equipped with an agitator, a thermometer, a reflux condenser, a dropping funnel, and a tube for introducing nitrogen was charged with 400 parts of carbitol acetate and 212 parts of Epichron N-695 which is a cresol-novolak resin (an epoxy equivalent of 220, manufactured by Dainippon Ink Kagaku Kogyo, Ltd.), followed by thermally melting. Subsequently, there were added 0.5 part of methylhydroquinone which is a polymerization inhibitor and 2 parts of triphenyl phosphine which is a catalyst for reaction. Mixture was heated to 100 °C, and there was dropped 248 parts (0.95 equivalent) of the carboxylic group containing - teminated acrylate (a) in which 0.5 piece of ε-caprolactone is added on an average and modified by maleic anhydride in the above (Synthesis Example IV-1). After having aged for 10 hours, it was cooled to 80 °C, and 139 parts of tetrahydrophthalic anhydride was added, and aged for 8 hours, followed by cooling to obtain a desired resin (AIV-2). In the resin obtained, nonvolatile components were 60%, and an acid value of solid components was 80 mgKOH/g.

### (Synthesis Example IV-3)

A 2L separable flask equipped with an agitator, a thermometer, a reflux condenser, a dropping funnel, and a tube for introducing nitrogen was charged with 250 parts of carbitol acetate, followed by simultaneously dropping 137 parts of glycidyl methacrylate (Blemmer G which is a trade name by Nihon Yushi, Ltd.), 75 parts of methylmethacrylate, 150 parts of carbitol acetate, and 2.1 parts of t-butyl-peroxy-2-ethylhexanoate (Perbutyl O manufactured by Nihon Yushi, Ltd.) over 3 hours. After having dropped, aging was conducted for 3 hours to obtain a base resin having epoxy groups.

Subsequently, there were added 0.5 part of methyl hydroquinone which is a polymerization inhibitor and 2 parts of triphenyl phosphine which is a catalyst for reaction. Mixture was heated to 100 °C, and there was dropped 248 parts (0.95 equivalent) of the carboxylic group containing - teminated acrylate (a) in which 0.5 piece of ε-caprolactone is added on an average and modified by maleic anhydride. After having aged for a reaction over 10 hours, it was cooled to 80 °C, and 139 parts of tetrahydrophthalic anhydride was added, and aged for 8 hours, followed by cooling to obtain a desired resin (AIV-3). In the resin obtained, nonvolatile components were 60%, and an acid value of solid components was 86 mgKOH/g.

### (Synthesis Example IV-4)

A 2L separable flask equipped with an agitator, a thermometer, a reflux condenser, a dropping funnel, and a tube for introducing nitrogen was charged with 250 parts of carbitol acetate, followed by simultaneously dropping 177 parts of 3,4-epoxycyclohexyl methylacrylate (Cyclomer A200 manufactured by Daicel Chemical Industries, Ltd.), 30 parts of methylmethacrylate, 150 parts of carbitol acetate, and 2 parts of t-butyl-peroxy-2-ethylhexanoate (Perbutyl O manufactured by Nihon Yushi, Ltd.) over 3 hours. After having dropped, aging was conducted for 3 hours to obtain a base resin having epoxy groups. Subsequently, there were added 0.5 part of methyl hydroquinone which is a polymerization inhibitor and 2 parts of triphenyl phosphine which is a catalyst for reaction.

Mixture was heated to 100 °C, and there was dropped 248 parts (0.95 equivalent) of the carboxylic group containing - teminated acrylate (a) in which 0.5 piece of ε-caprolactone is added on an average and modified by maleic anhydride. After having aged for a reaction over 10 hours, it was cooled to 80 °C, and 139 parts of tetrahydrophthalic anhydride was added, and aged for 8 hours, followed by cooling to obtain a desired resin (AIV-4). In the resin obtained, nonvolatile components were 60%, and an acid value of solid components was 86 mgKOH/g.

### (Synthesis Example IV-5)

First of all, a carboxylic group containing - teminated acrylate (b) in which 0.5 piece of ε-caprolactone is added on an average to acrylic acid was synthesized as described below

A four-necked flask having equipped with a tube for introducing air, a thermometer, a condenser, and an agitation device was charged with 313 parts acrylic acid (AA), 10 parts of paratoluene sulphonic acid, and 0.1 part of hydroquinone monomethylether which is a polymerization inhibitor, and 248 parts of ε-caprolactone was dropped over 4 hours and reaction was further conducted for 2 hours to obtain a desired compound.

Subsequently, a 2L separable flask equipped with an agitator, a thermometer, a reflux condenser, a dropping funnel, and a tube for introducing nitrogen was charged with 400 parts of carbitol acetate and 271 parts of Epichron N-695 which is a cresol-novolak resin (an epoxy equivalent of 220, manufactured by Dainippon Ink Kagaku Kogyo, Ltd.), followed by thermally melting. Subsequently, there were added 0.5 part of methyl hydroquinone which is a polymerization inhibitor and 2 parts of triphenyl phosphine which is a catalyst for reaction. Mixture was heated to 100 °C, and there was dropped 151 parts (0.95 equivalent) of the carboxylic group containing - teminated acrylate (b) in which 0.5 piece of ε-caprolactone is added on an average to acrylic acid. After having aged for a reaction over 10 hours, it was cooled to 80 °C, and 163 parts of tetrahydrophthalic anhydride was added, and aged for 8 hours, followed by cooling to obtain a desired resin (AIV-5). In the resin obtained, nonvolatile components were 60%, and an acid value of solid components was 87 mgKOH/g.

### (Synthesis Example IV-6)

A 2L separable flask equipped with an agitator, a thermometer, a reflux condenser, a dropping funnel, and a tube for introducing nitrogen was charged with 250 parts of carbitol acetate, followed by simultaneously dropping 224 parts of glycidyl methacrylate (Blemmer G), 123 parts of methylmethacrylate, 150 parts of carbitol acetate, and 2.6 parts of t-butyl-peroxy-2-ethylhexanoate (Perbutyl O manufactured by Nihon Yushi, Ltd.) over 3 hours. After having dropped, aging was conducted for 3 hours to obtain a base resin having epoxy groups. Subsequently, there were added 0.5 part of methyl hydroquinone which is a polymerization inhibitor and 2 parts of triphenyl phosphine which is a catalyst for reaction.

Mixture was heated to temperature of 100 °C, and there was dropped 108 parts (0.95 equivalent) of acrylic acid. After having aged for a reaction over 10 hours, it was cooled to 80 °C, and 144 parts of tetrahydrophthalic anhydride was added, and aged for 8 hours, followed by cooling to obtain a desired resin (AIV-6).

In the resin obtained, nonvolatile components were 60%, and an acid value of solid components was 88 mgKOH/g.

### (Synthesis Example IV-7)

First of all, there was synthesized a carboxylic group containing - teminated acrylate (c) in which 4 pieces of ε -caprolactone is added on an average and modified by maleic anhydride as described below.

A four-necked flask having equipped with a tube for introducing air, a thermometer, a condenser, and an agitation device was charged with 126 parts 2-hydroxyethylacrylate (2-HEA), 496 parts of ε-caprolactone, 0.368 part of hydroquinone monomethylether, 0.148 part of monobutyltin tris-2-ethylhexanate, followed by allowing to react at 100 °C for 7 hours while streaming air to obtain an adduct in which 4 mol of ε-caprolactone is added on an average. Subsequently, 106 parts of maleic anhydride was added and reaction was conducted at 90 °C for approximately 8 hours to obtain a desired compound.

Subsequently, a 2L separable flask equipped with an agitator, a thermometer, a reflux condenser, a dropping funnel, and a tube for introducing nitrogen was charged with 250 parts of carbitol acetate, followed by simultaneously dropping 92 parts of glycidyl methacrylate (Blemmer G), 5 parts of methylmethacrylate, 150 parts of carbitol acetate and 0.9 parts of t-butyl-peroxy-2-ethylhexanoate (Perbutyl O manufactured by Nihon Yushi, Ltd.) over 3 hours. After having dropped, aging was conducted for 3 hours to obtain a base resin having epoxy groups. Subsequently, there were added 0.5 part of methyl hydroquinone which is a polymerization inhibitor and 2 parts of triphenyl phosphine which is a catalyst for reaction. Mixture was heated to 100 °C, and there was dropped 410 parts (0.95 equivalent) of the carboxylic group containing - teminated acrylate (c) in which 4 pieces of ε-caprolactone is added on an average and modified by maleic anhydride. After having aged for 10 hours, it was cooled to 80 °C, and 93 parts of tetrahydrophthalic anhydride was added, and aged for 8 hours, followed by cooling to obtain a desired resin (AIV-7). In the resin obtained, nonvolatile components were 60%, and an acid value of solid components was 60 mgKOH/g.

### (Synthesis Example IV-8)

A 2L separable flask equipped with an agitator, a thermometer, a reflux condenser, a dropping funnel, and a tube for introducing nitrogen was charged with 400 parts of carbitol acetate and 348 parts of Epichron N-695 which is a cresol-novolak resin (an epoxy equivalent of 220, manufactured by Dainippon Ink Kagaku Kogyo, Ltd.), followed by thermally melting. Subsequently, there were added 0.5 part of methyl hydroquinone which is a polymerization inhibitor and 2 parts of triphenyl phosphine which is a catalyst for reaction. Mixture was heated to 100°C, and there was dropped 108 parts (0.95 equivalent) of acrylic acid. After having aged for 10 hours, it was cooled to 80 °C, and 144 parts of tetrahydrophthalic anhydride was added, and aged for 8 hours, followed by cooling to obtain a desired resin (AIV-8). In the resin obtained, nonvolatile components were 60%, and an acid value of solid components was 89 mgKOH/g.

### (Examples IV-1 to IV-5 and Comparative Examples IV-1 to IV-3)

There were mixed respective 100 parts by weight (a solid content) of the resin solutions AIV-1 to AIV-8, 20 parts by weight of trimethylolpropane triacrylate, 20 parts by weight of a cresol-novolak type epoxy resin (Epikote 180S70 manufactured by Yuka Shell Epoxy, Ltd.), 7 parts by weight of benzylmethyl ketal, 2 parts by weight of diethyl thioxanthone, 1.5 part of a Phthalocyanine Green, 5 parts by weight of silica, and 20 parts by weight of barium sulphate, and 5 parts by weight of dicyandiamide, followed by kneading with a three-rolls kneader to obtain a viscous ink composition.

Subsequently, the ink composition obtained was coated in thickness of 20 µm on a substrate on which a pattern is formed using a barcoater, and it was dried at 80 °C for 20 minutes with an air-circulating dryer. After that, a contact exposure to light was conducted using a negative film with an irradiation dose of 800 mJ/ cm². After that, development was conducted using 1% sodium carbonate aqueous solution, and a coating layer obtained was cured at 150 °C for 30 minutes in an air circulating oven to obtain a cured coating layer. Sensitivity and finger touch dryability was checked in relation to the coating layer obtained. Results are shown in Table IV-1.

**Table IV-1**

| | Examples | | | | | Comparative Examples | | |
|---|---|---|---|---|---|---|---|---|
| | IV-1 | IV-2 | IV-3 | IV-4 | IV-5 | IV-1 | IV-2 | IV-3 |
| Resin*1 | AIV-1 | AIV-2 | AIV-3 | AIV-4 | AIV-5 | AIV-6 | AIV-7 | AIV-8 |
| Sensitivity | 13 | 12 | 12 | 12 | 12 | 10 | 10 | 11 |
| Finger touch Dryability | o | o | o | o | o | o | x | o |
| Resin* 1: Resin employed for an ink composition | | | | | | | | |

The above respective evaluations were conducted as follows.

Sensitivity was evaluated using a Stoeffer 21-stages step tablet.

Finger touch dryability was evaluated according to the following rules by checking finger-touched tackiness after having dried.
- o:: Tackiness is not observed.
- △:: Tackiness is slightly observed.
- x:: Tackiness is observed.

As shown in the Examples, a resin can be readily synthesized according to the present invention IV, and there can be provided a photocurable resin composition which is well-balanced between ink sensitivity and tackiness which are shown by step stage evaluations.

### Possibility of utilization in Industry

According to the present invention I, it was able to develop by water, and water resistance is improved in a cured coating layer, and it becomes unnecessary to conduct pH control of a developer which is problematic in alkali development.

According to the present invention II, it was able to stably prepare fine precision rib patterns on a large-sized substrate for a PDP without a problem of a change to the worse in working circumstances, with an excellent yield and good productivity.

In the present invention III, a coating layer in a photoresist obtained is excellent in physical properties such as adhesion and hardness, and it is particularly useful as a liquid-state etching and solderresist resin composition for the preparation of a printed circuit board.

In the present invention IV, a resin can be readily synthesized, and there can be provided a photocurable resin composition which is well-balanced between ink sensitivity and tackiness which are shown by step stage evaluations.

## Claims

1. A water-developable type photocurable resin composition **characterized by** containing a resin (I-A) having hydroxyl groups and polymerizable unsaturated groups, a photo-polymerizable initiator (B), and a photopolymerizable monomer (I-C).

2. A water-developable type photocurable resin composition as claimed in claim 1, wherein a hydroxyl group value is 50-800 mgKOH/g in said resin (I-A) having hydroxyl groups and polymerizable unsaturated groups.

3. A water-developable type photocurable resin composition as claimed in claim 1 or 2, wherein said resin (I-A) having hydroxyl groups and polymerizable unsaturated groups has a weight average molecular weight of 1,000-50,000, a hydroxyl group value is 50-800 mgKOH/g, and a double bond equivalent is 400-2,000.

4. A water-developable type photocurable resin composition as claimed in any one of claims 1-3, wherein a resin (I-A') having an acid value of 1-100 mgKOH/g is employed alone or mixed with said resin (I-A), and said resin (I-A') being obtained by a reaction of said resin (I-A) having hydroxyl groups and polymerizable unsaturated groups with an acid anhydride.

5. A water-developable type photocurable resin composition as claimed in any one of claims 1-4, wherein said resin having hydroxyl groups is a polyglycerine.

6. A water-developable type photocurable resin composition as claimed in any one of claims 1-5, wherein a pigment is further contained.

7. A photocurable resin composition wherein the water-developable type photocurable resin composition as claimed in any one of claims 1-6 is added to a composition, which is used for any one of uses selected from a liquid resist, a dry film, or a pigment resist for a dry film, a color filter for a liquid crystal display, or a black-colored matrix.

8. A thermosetting resin-composition wherein the water-developable type photocurable resin composition as claimed in any one of claims 1-6 is added to a composition, which is used for any one of uses selected from a liquid resist or a pigment resist for a dry film, a color filter for a liquid crystal display, and a black-colored matrix.

9. A water-developable type photocurable resin composition as claimed in any one of claims 1-3, wherein a solvent for dilution (D) is further contained.

10. A water-developable type photocurable resin composition as claimed in claim 9, wherein there are further contained a glass frit (E), a phosphoric acid compound (F), and ceramics powder (G).

11. A water-developable type photocurable resin composition as claimed in claim 9 or 10, wherein a black-colored pigment (H) is further contained.

12. A water-developable type photocurable resin composition as claimed in claim 10, wherein a glass transition point in the glass frit (E) is 300-550 °C.

13. A water-developable type photocurable resin composition as claimed in claim 11, wherein said black-colored pigment (H) is a metal oxide pigment essentially containing one or more kinds of oxides of Fe, Cr, Mn, and Co, and there is contained the metal oxide pigment in a proportion of 3-100 parts by weight based on 100 parts by weight of said glass frit (E).

14. A water-developable type photocurable resin composition as claimed in any one of claims 9-13, wherein a developer is a diluted alkali aqueous solution.

15. A method for the preparation of a separating rib for a plasma display panel **characterized by** including a step for the formation of a coating layer by coating a water-developable type photocurable resin composition as claimed in any one of claims 9-14 on a substrate for a plasma display panel, a step for exposing the coating layer to light by an active beam depending upon a fixed pattern, a step for removing unexposed portions of the coating layer after having developed by water or a diluted alkali aqueous solution, and a step for calcining the coating layer after having developed.

16. A photoresist resin composition for a printed circuit board which comprises formulating an organic solvent (S) and/or a polymerizable vinyl monomer (III-C) with a modified copolymer (III-A1), and said modified copolymer (III-A1) being obtained by an addition reaction of a carboxylic group-contained resin (p) with a cycloaliphatic epoxy group-contained ethylenic unsaturated compound (c), and said carboxylic group-contained resin (p) being obtained by a polymerization of a carboxylic group-contained ethylenic unsaturated compound (a) as an essential monomer component.

17. A photoresist resin composition for a printed circuit board which comprises formulating an organic solvent (S) and/or a polymerizable vinyl monomer (III-C) with a modified copolymer (III-A2), and said modified copolymer (III-A2) being obtained by a reaction of a cycloaliphatic epoxy group-contained resin (q) with a carboxylic group-contained ethylenic unsaturated compound (a), and said resin (q) being obtained by a polymerization of a cycloaliphatic epoxy group-contained ethylenic unsaturated compound (c) as an essential monomer component.

18. A photoresist resin composition for a printed circuit board as claimed in claim 16 or 17, wherein said organic solvent (S) is glycol ethers.

19. A photoresist resin composition for a printed circuit board as claimed in claim 18, wherein said glycol ethers are dipropyleneglycol monomethylether.

20. A photoresist resin composition for a printed circuit board as claimed in claim 19, wherein an isomer component (iii) is not more than 25% by weight based on total isomers (i) to (iv) of formulae described below in dipropyleneglycol monomethylether.

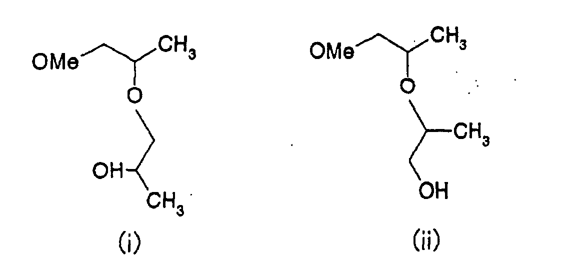

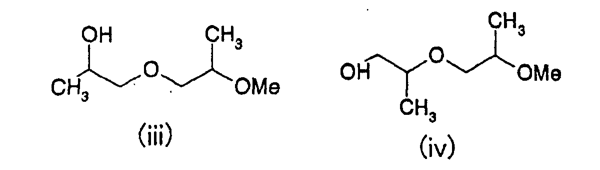

21. A photocurable resin composition containing a monomer composition (IV-a) having a terminal carboxylic group represented by a formula (1) described below, wherein a hydroxy-terminated (meth)acrylate is modified by an acid anhydride and, in said (meth)acrylate, 0.3 to less than 1 mol of ε-caprolactone is added to 1 mol of a hydroxyalkyl(meth)acrylate on an average,
CH₂=CR¹-COOR²O(COC₅H₁₀O)ₙCOR³-COOH (1)
R¹ represents a hydrogen or a methyl group,
R² represents a hydrocarbon group having a carbon number of 1-5 or an aromatic ring hydrocarbon group,
R³ represents a saturated or unsaturated aliphatic or cycloaliphatic hydrocarbon group or an aromatic ring hydrocarbon group, and average value of n ranges from 0.3 to less than 1.

22. A photocurable resin composition containing a monomer composition (IV-b) having a terminal carboxylic group represented by formula (2) described below, wherein 0.3 to less than 1 mol of ε-caprolactone is added to 1 mol of a (meth)acrylic acid on an average,
CH₂=CR¹-CO(OC₅H₁₀CO)ₙOH (2)
R¹ represents a hydrogen or a methyl group, average value of n ranges from 0.3 to less than 1.

23. A photocurable resin composition containing a compound (IV-c) in which the monomer composition (IV-a) or (IV-b) as claimed in claim 21 or 22 is added to a compound having at least two epoxy groups in the molecule.

24. A photocurable resin composition containing a compound (IV-d) in which said compound (IV-c) as claimed in claim 23 is further modified by an acid anhydride.
